# EUROPEAN PATENT APPLICATION

(11) **EP 2 648 228 A2**
(43) Date of publication of application: **09.10.2013**
(21) Application number: 11844905.7
(22) Date of filing: 02.12.2011
(51) Int. Cl.: H01L 31/042

(54) **TREE-SHAPED SOLAR CELL MODULE**

(30) Priority: 03.12.2010 KR 20100122380; 09.12.2010 KR 20100125294; 11.06.2011 KR 20110056552
(71) Applicant: Kim, Han Sik, Jeollabuk-do 597-803 (KR)
(72) Inventor: Kim, Han Sik, Jeollabuk-do 597-803 (KR)
(74) Representative: Zardi, Marco
(86) International application number: PCT/KR2011/009342
(87) International publication number: WO 2012/074341

(57) **Abstract**

A tree-shaped solar cell module includes branch modules and a trunk module which are assembled with each other into the tree-shaped solar cell module. Each branch of the tree-shaped solar cell module has high strength to be prevented from being shaken with wind, and each branch does not have twigs or leaves and is thus prevented from being shaken by wind. Each branch may have an circular or polygonal shape such as a triangular shape or a quadrangular shape so that sunlight may evenly come to the tree-shaped solar cell module. Like branches of a tree which are directed upwardly, downwardly or horizontally, the branch modules may be assembled in such a manner that the branch modules have angles in a horizontal, upward or downward direction from the trunk module. The tree-shaped solar cell module may be installed in any sunny place even if it is a steep mountain with a large slope, a field of a flatland or a desert, and may be installed in a tree-planting manner without the need of reclamation and flattening of land. Grasses may grow all around the area where the tree-shaped solar cell module is installed to achieve a green area and the green area may be used as a ranch or a farm. If the tree-shaped solar cell module is installed in a desert area, it can be placed far away from the ground and less influenced by the radiant heat of the ground, thus preventing degradation of efficiency caused by high temperature. As the land of China is being rapidly desertified, the tree-shaped solar cell module of the present invention may be installed in the land of China to adjust the intensity of wind and thus limit sand transport and set up an environment that allows plants to grow, thus enabling solar generation that saves the earth.

## Description

### Cross-Reference to Related Application

This application is the national phase application of International Application No. PCT/KR2011/009342, filed on December 2, 2011, which claims the benefit of Korean Patent Application Nos. 10-2010-0122380, filed on December 3, 2010, 10-2010-0125294, filed on December 9, 2010, and 10-2011-0056552, filed on June 11, 2011, the entire contents of which are incorporated herein by reference.

### Technical Field

The present invention relates tree-shaped solar cell modules formed by combining solar cells in the form of trees for easy installation and solar power generation at various places.

The tree-shaped solar cell modules can be installed in the yards or gardens of houses or the rooftops of buildings to provide green zones and electricity necessary for the houses or buildings.

The tree-shaped solar cell modules can regularly be arranged along the center regions, boundary regions, or ridges of rice paddies, fields, or orchards for solar power generation, and since the tree-shaped solar cell modules can function as wind blocks, crops can be protected from typhoons and the like. For example, falling of crops or fruits may be prevented when a typhoon blows.

The tree-shaped solar cell modules can be installed like trees at regular intervals in a large farm for generating electricity without affecting farming.

The tree-shaped solar cell modules can be installed along a railroad to supply electricity necessary for trains.

The tree-shaped solar cell modules can be installed along a road or street as street trees, utility poles, streetlamps, antennas, and traffic lights.

The tree-shaped solar cell modules can be installed along or around waterways, reservoirs, lakes, or dams for converting sunlight into electricity.

The tree-shaped solar cell modules can be installed between trees on a mountain without having to remove trees from the mountain. In addition, the tree-shaped solar cell modules can easily be installed on a mountain slope which is too steep to plant crops so that such a steep mountain slope can be valuably used.

The tree-shaped solar cell modules can be installed like trees in a desert for solar power generation. In this case, since the tree-shaped solar cell modules function as wind blocks, sand may be less blown by wind, and plants such as grasses and trees may easily grow around the tree-shaped solar cell modules, thereby preventing desertification and developing green land.

Large tree-shaped solar cell modules can be installed in a desert. In this case, solar cells can be distant from the surface of the desert for reducing the influence of geothermal heat. This compensates for the disadvantage that the efficiency of silicon crystalline solar cells reduce as temperature increases.

In the related art, there are panel type solar cell modules and concentrated solar cell modules. Solar cells are arranged on a panel and are wired up, and the panel is covered and fixed to form a large solar cell module. Such solar cell modules may be arranged on the rooftops of small buildings, large areas developed from mountains, foreshores, or deserts for solar power generation.

Panel type solar cell modules of the related art have several disadvantages. First, although solar power is a kind of new regeneration energy, green areas are destroyed when mountains are developed for installing panel type solar cell modules, and the marine ecosystem may be damaged if panel type solar cell modules are arranged on a foreshore or sea. As a result, solar power cannot be green energy because green areas are destroyed to install panel type solar cell modules.

If such panel type solar cell modules of the related art are installed in a desert, the power generation efficiency of the solar cell modules reduces due to the high temperature of the desert.

After installation, such panel type solar cell modules are sloped and oriented in the same direction. Therefore, the solar cell modules can not be efficiently operated according to the movement of the sun. If the solar cell modules are configured to move according to the movement of the sun, the manufacturing costs increase, and energy loss increases. In addition, parts such as motors and bearings may be worn down and become out of order according to the time of use.

### Background Art

The present patent application claims priority of the following patent applications: Original Application, Priority Application 1, and Priority Application 2.

ORIGINAL APPLICATION Title of Invention: Tree-shaped solar cell module, Korean Patent Application No.: 10-2010-0122380, and Filing Date: December 3, 2010.

PRIORITY APPLICATION Title of Invention: Tree-shaped solar cell module, Korean Patent Application No.: 10-2010-0125294, and Filing Date: December 9, 2010.

PRIORITY APPLICATION Title of Invention: Tree-shaped solar cell module, Korean Patent Application No.: 10-2011-0056552, and Filing Date: June 11, 2011.

Patent applications searched at Korean Intellectual Property Rights Information Service (KIPRIS) are listed below.

[Literature 1] Title of Invention: Leaf solar-cell equipped tree type electric power generation system, Korean Patent Application Publication No.: 10-2010-0047999, Publication Date: May 11, 2010.

[Literature 2] Title of Invention: Tree-type solar power generator, Korean Patent Application Publication No.: 10-2011-0030392, Publication Date: March 23, 2011.

[Literature 3] Japanese Patent Application Laid-Open Publication No.: 2004-281788 (October 7, 2004).

The three applications are listed as reference.

### SUMMARY OF INVENTION

### Technical Problem

The present invention provides solar cell modules in the form of a branch module, a trunk module, and a tree-shaped solar cell module in which the branch module and the trunk module are combined.

The tree-shaped solar cell module can also be used as a utility pole and a streetlamp, and the tree-shaped solar cell module does not include a structure that can be easily swung by wind.

### Solution to Problem

A triangular branch module includes: a triangular frame formed of a material such as metals, concrete, wood, ceramic materials, and plastics and having a length of about 2 m to about 3 m; and solar cells are attached to the three sides of the triangular frame.

A trunk module includes an octagonal frame having a length of about 6 m to about 10 m and solar cells attached to the eight sides of the octagonal frame.

A fixing plate that can be fixed to the trunk module is provided on an end of the triangular branch module.

Nut holes are regularly formed in a lateral outer side of the trunk module so that the triangular branch module can be fixed to the trunk module.

The triangular branch module or the trunk module may include a polygonal or circular frame such as a triangular frame, a quadrangular frame, a pentagonal frame, a hexagonal frame, a heptagonal frame, and an octagonal frame.

In the triangular branch module or the trunk module, an assembly space region is formed in each side of the polygonal or circular frame such as a triangular frame, a quadrangular frame, a pentagonal frame, a hexagonal frame, a heptagonal frame, and an octagonal frame so that solar cells can be easily attached thereto.

In the triangular branch module or the trunk module, an internal cavity is formed in the polygonal or circular frame such as a triangular frame, a quadrangular frame, a pentagonal frame, a hexagonal frame, a heptagonal frame, and an octagonal frame.

A wire accommodation groove is formed in the assembly space region so that wires can be arranged therein.

Penetration holes are regularly formed in the wire accommodation groove to connect the wire accommodation groove and the internal cavity.

When a solar cell is attached to the assembly space region, wires of the solar cells are arranged in the wire accommodation groove and introduced into the internal cavity.

After solar cells are attached to the assembly space region of the trunk module, the triangular branch module is fixed to the nut holes formed in the lateral outer side of the trunk module, so as to form a tree-shaped solar cell module.

A utility pole crossarm and a transformer may be attached to an upper portion of the tree-shaped solar cell module so that the tree-shaped solar cell module can also be used as a utility pole.

An LED module may be attached to one side of the triangular branch module to use the triangular branch module as a streetlamp.

Leaf-shaped solar cells are not included in the triangular branch module of the tree-shaped solar cell module so that the tree-shaped solar cell module may not easily swung by wind.

### Advantageous Effects of Invention

The tree-shaped solar cell module can be installed like a tree on sunny flatland or a steep slope of a mountain without reclamation or leveling.

When installing the tree-shaped solar cell module on a mountain, it is unnecessary to remove trees around the tree-shaped solar cell module as long as the trees interfere with the tree-shaped solar cell module. That is, forests can be conserved.

Since grasses can grow on the field or flatland around the tree-shaped solar cell module, the field or flatland where tree-shaped solar cell modules are installed can be used for farming. That is, the tree-shaped solar cell modules can be harmonized with the surrounding environments as new regeneration energy sources.

When the tree-shaped solar cell modules are installed in a desert, since solar cells are distant from the ground, solar power regeneration is less affected by geothermal heat, and thus efficiency reduction cased by high temperature can be prevented.

The tree-shaped solar cell modules of the present invention can be installed in a region of China suffering desertification for weakening wind, reducing transfer of sand, and forming environments suitable for growing plants.

### Brief Description of Drawings

FIGS. 1a, 1b, and 1c are a perspective view of a triangular branch module 100, a cross-sectional view of a triangular frame 10, and a cross-sectional view for explaining assembly procedures of solar cells 18.
FIGS. 2d, 2e, 2f, and 2g are a perspective view of a quadrangular branch module 110, a perspective view of a rhombus branch module 120, a cross-sectional view of a quadrangular frame 10a, and a cross-sectional view for explaining assembly procedures of simple solar cell modules 22.
FIGS. 3h and 3k are a cross-sectional view of a hexagonal frame 10b and a cross-sectional view for explaining assembly procedures of simple solar cell modules 22.
FIGS. 4m, 4n, and 4p are a perspective view of a circular branch module 130, a cross-sectional view of a circular frame 10d, and a perspective view for explaining assembly procedures of simple solar cell modules 22d.
FIGS. 5q and 5r are a plan view and a perspective view for explaining assembly procedures of a triangular pillar 40, module auxiliary frames 50, and simple solar cell modules 22.
FIGS. 6s and 6t are a plan view and a perspective view for explaining assembly procedures of a triangular pillar 40, angled end parts 55b, and simple solar cell modules 22.
FIGS. 7u and 7v are a plan view and a perspective view for explaining assembly procedures of an octagonal pillar 40c, module auxiliary frames 50, and simple solar cell modules 22.
FIGS. 8w and 8x are a plan view and a perspective view for explaining assembly procedures of a circular pillar 40d, module auxiliary parts 50b, and simple solar cell modules 22.
FIGS. 9y and 9z are a plan view and a perspective view for explaining assembly procedures of a circular pillar 40d, module auxiliary frames 50b, and simple solar cell modules 22c.
FIGS. 10a1 and 10b1 are a plan view and a perspective view for explaining how a simple solar cell module 22 is attached to a branch module single frame 60.
FIGS. 11c1 and 11d1 are a plan view and a perspective view for explaining how simple solar cell modules 22 are attached to a branch module dual frame 60a.
FIGS. 12e1 and 12f1 are a plan view and a perspective view for explaining how simple solar cell modules 22 are attached to a branch module multiple frame 60b.
FIGS. 13g1 and 13h1 are a plan view and a perspective view for explaining how a simple solar cell module 22d is attached to a branch module curve frame 60d.
FIG. 14 is a transparent view showing how a trunk module 200 is fixed to a base 85 and how lines 89 extending from a line part 88 of the base 85 are laid in the ground.
FIG. 15 is a transparent view showing a lightening rod 1 attached to an end portion 83 of the trunk module 200 which is fixed to the base 85 as shown in FIG. 14.
FIG. 16 is an enlarged perspective view showing a portion of the trunk module 200.
FIG. 17 is a view showing a tree-shaped solar cell module 400 in which rhombus branch modules 120 are attached to a trunk module 200.
FIG. 18 is a partially enlarged view of FIG. 17 showing the rhombus branch modules 120.
FIG. 19 is a perspective view for explaining how branch coupling parts 90 are attached to the trunk module 200.
FIG. 20 is a perspective view showing the trunk module 200 of FIG. 19 after the branch coupling parts 90 are attached thereto.
FIG. 21 is a perspective view showing rhombus branch modules 120 attached to connection portions 92 of the branch coupling parts 90 shown in FIG. 20.
FIG. 22 is a view showing a tree-shaped solar cell module 500 assembled using branch coupling parts 90.
FIG. 23 is a view showing one-piece supports 35 and fixing plates 36 for attaching branch modules to a trunk module 200.
FIG. 24 is a perspective view showing a tree-shaped solar cell module 600 having electric pole crossarms 2 for being used as a utility pole, traffic lights, streetlights, or the like.
FIG. 25 is a view showing a tree-shaped solar cell module 650 in which flowerpots 77 having internal cavities are fixed to fixing portions 78 of a trunk module 200 at positions higher than a predetermined lower position so that tree roots can be put in the internal cavities to use the tree-shaped solar cell module 650 as street trees as well.
FIGS. 26k1 and 26ml are a perspective view of a tree-shaped solar cell module 700 and a partially enlarged perspective view of a branch module 140.
FIGS. 27n1 and 27p1 are a perspective view of a tree-shaped solar cell module 710 and a partially enlarged perspective view of a branch module 150.
FIGS. 28q1 and 28r1 are a perspective view of a tree-shaped solar cell module 720 and a partially enlarged perspective view of a branch module 160.
FIGS. 29s1 and 29t1 are a perspective view of a tree-shaped solar cell module 730 and a partially enlarged perspective view of a branch module 170.
FIG. 30 is a plan view showing the tree-shaped solar cell module 730.
FIG. 31 is a perspective view showing a tree-shaped solar cell module 730 to which more branch modules 170 are attached.
FIG. 32 is a plan view showing the tree-shaped solar cell module 730 of FIG. 30.
FIGS. 33t, 33u, and 33v are views showing trunk modules 200 to which branch modules such as triangular branch modules 100, quadrangular branch modules 110, rhombus branch modules 120, and circular branch modules 130 are respectively attached in an upward pattern (FIG. 33t), a horizontal pattern (FIG. 33u), and a downward pattern (FIG. 33v).

### Description of Embodiments

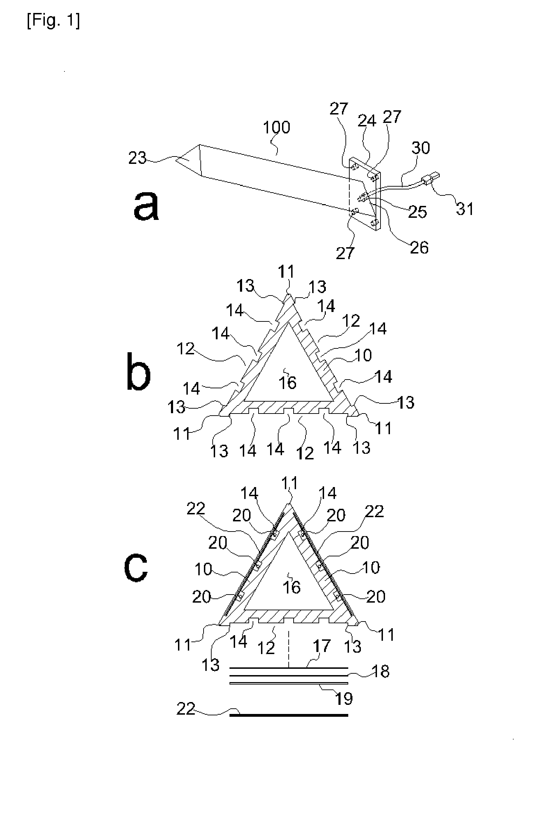

Configurations and embodiments of the present invention will now be described with reference to the accompanying drawings. FIG. 1a is a perspective view showing a triangular branch module 100. The triangular branch module 100 includes a pillar frame such as a triangular frame and solar cells attached to three sides of the triangular frame for generating electricity from sunlight. Such triangular branch modules 100 will be disposed around a trunk module 200 (described later) and fixed to the trunk module 200 like tree branches so as to form a tree-shaped solar cell module.

Referring to FIGS. 1a, 1b, and 1c, the triangular frame 10 of the triangular branch module 100 may be formed through processes such as extrusion, molding, assembling, and cutting. Materials that can be used for forming the triangular frame 10 include a metal such as aluminum and stainless steel, a ceramic material such as glass and concrete, resin such as plastic resin or vinyl resin, and combinations thereof. Even wood may be used for forming the triangular frame 10. If the triangular frame 10 is formed of concrete, concrete including cement may be put in a mould together with reinforcing materials such as steel reinforcing bars, wires, and wire meshes. If the triangular frame 10 is formed of wood, the triangular frame 10 may be treated with a waterproof agent for waferproofing and insect proofing as well.

Assembly space regions 12 as large as possible are formed by recessing the three sides of the triangular frame 10 by 5 mm to 10 mm so as to attach solar cells thereto, and both sides of each corner 11 of the triangular frame 10 protrude as jaws 13 because of the relatively low assembly space regions 12. The jaws 13 protrude away from the assembly space regions 12.

An internal cavity 16 is formed in the triangular frame 10. In the drawings, the internal cavity 16 has a triangular shape. However, the triangular frame 10 may have a circular or polygonal internal cavity 16 or may be solid without any internal cavity 16 according to manufacturing processes. In the present invention, the internal cavity 16 may be useful for arranging wires, and the shape and size of the internal cavity 16 may be determined according to a material used to form the triangular frame 10 so as to maintain the strength of the triangular frame 10.

At least one wire accommodation groove 14 having a depth toward the internal cavity 16 is formed on each of the assembly space regions 12 so that electric wires can be arranged in the wire accommodation grooves 14 when solar cells are attached to the assembly space regions 12.

Penetration holes (not shown) connecting the wire accommodation grooves 14 and the internal cavity 16 are regularly arranged in the length direction of the triangular frame 10, that is, in a direction from a module end 23 of the triangular branch module 100 to a fixing part 26 as shown in FIG. 1a, so that when solar cells are attached to the assembly space regions 12, wires of the solar cells can be arranged from the wire accommodation grooves 14 to the internal cavity 16 through the penetration holes.

A fixing plate 24 is provided on an end of the triangular frame 10 so that the triangular frame 10 can be fixed to the outside of the trunk module 200 (described later) like a branch. According to the angle between the fixing plate 24 and the fixing part 26 of the triangular frame 10, the angle of the triangular frame 10 and the orientations of the three sides of the triangular frame 10 are determined with respect to the vertical position of the fixing plate 24.

Since the fixing plate 24 is vertically held and fixed to the outside of the trunk module 200 like a branch, the triangular frame 10 can be positioned upwardly, horizontal, or downwardly according to the assembling angle and directions of the fixing plate 24 and the fixing part 26 of the triangular frame 10.

Therefore, when the triangular branch module 100 is attached to the trunk module 200, the position of the triangular branch module 100 can be adjusted upward, horizontal, or downward. That is, it is apparent that the angle of the triangular branch module 100 from the trunk module 200 can be adjusted within a range smaller than the plane angle (180 degrees) of the trunk module 200 that will be installed vertically like a tree trunk.

When the triangular branch module 100 provided by attaching solar cells to the triangular frame 10 is assembled to the trunk module 200, the three sides of the triangular frame 10 can be positioned at 0, 120, and 240 degrees, or 60, 180, and 300 degrees. That is, the three sides of the triangular frame 10 can be positioned in predetermined orientations within the 360-degree range by adjusting the orientation of the fixing plate 24 so that simple solar cell modules 22 attached to the triangular frame 10 can be oriented to receive sunlight effectively.

The fixing plate 24 is a plate that can be fixed to the trunk module 200, and for this, fixing holes 27 are formed through the corners of the fixing plate 24.

A wire hole 25 formed through the center portion of the fixing plate 24 is connected to the internal cavity 16.

Electric wires 20 of solar cells 18 of the simple solar cell modules 22 are arranged in the wire accommodation grooves 14 and the internal cavity 16 and come out through the wire hole 25 of the fixing plate 24. The electric wires 20 coming out through the wire hole 25 will now be referred to as connection wires 30, and a connection plug 31 is attached to the ends of the connection wires 30.

In the drawings showing an embodiment of the present invention, the fixing plate 24 has a rectangular shape. However, the fixing plate 24 may be manufactured in a different shape such as a quadrangular, circular, or polygonal shape.

Although not shown in the drawings of the embodiment, the fixing plate 24 may have an arch-shaped portion so that the fixing plate 24 can be attached to a circular pillar having a corresponding diameter.

Although not shown in the drawings of the embodiment, male screws may protrude from an end of the triangular branch module 100 or female screws may be formed in the end of the triangular branch module 100 instead of the fixing plate 24. In this case, corresponding female screws or male screws may be provided on the outside of the trunk module 200 for screw coupling with the triangular branch module 100. FIG. 1c is a cross-sectional view showing how parts such as sheets 17, solar cells 18, and transparent glass plates 19 are assembled to the assembly space regions 12 of the triangular frame 10. First, a sheet 17 may be attached to an assembly space region 12 of the triangular frame 10, and a solar cell 18 may be placed in the assembly space region 12. Then, wires 20 may be arranged in the wire accommodation grooves 14 and the internal cavity 16, and a transparent glass plate 19 may be placed on the solar cell 18 and fixed. These procedures may be repeated to form the triangular branch module 100 having a long shape.

The sheet 17, the solar cell 18, and the transparent glass plate 19 are fixed by applying an adhesive to the jaws 13 formed at the corners of the assembly space region 12. The fixing process may include a waterproof treatment.

The sheet 17, the solar cell 18, and the transparent glass plate 19 are well-known parts in the related art, and thus detailed descriptions thereof will not be provided.

Although now shown in the drawings, screw holes may be formed in portions of the sheet 17, the solar cell 18, and the transparent glass plate 19, and corresponding screw holes may be formed in the assembly space region 12 for assembly using screws. However, the use of an adhesive may be advantageous, and an adhesive known in the related art such as silicone may be used.

As described above, the sheet 17, the solar cell 18, and the transparent glass plate 19 may be sequentially assembled to the triangular frame 10. However, for efficiency, speed, and precision of an assembly process, the sheet 17, the solar cell 18, and the transparent glass plate 19 may be previously assembled as a simple solar cell module 22.

In the following descriptions, only simple solar cell modules 22 or simple solar cell modules 22d may be shown and described without describing individual parts thereof for simple and clear explanation.

That is, solar cells are previously assembled into simple solar cell modules 22, and then the simple solar cell modules 22 are attached to the assembly space regions 12 of the triangular frame 10 so that the triangular branch module 100 can be made simply, precisely, and rapidly.

FIG. 1b is a cross-sectional view of the triangular frame 10, and FIG. 1c is a sectional view showing how the sheets 17, the solar cells 18, and the transparent glass plates 19, or the simple solar cell modules 22 are attached to the triangular branch module 100.

In the above description and following description, the triangular frame 10 is a frame in which solar cells 18 or simple solar cell modules 22 are not yet attached to the assembly space regions 12, and the triangular branch module 100 is a module provided by attaching solar cells 18 or simple solar cell modules 22 to the assembly space regions 12 of the triangular frame 10, fixing the fixing plate 24 to an end of the triangular frame 10, and connecting the connection plug 31 to ends of the connection wires 30 coming out through the wire hole 25 of the fixing plate 24.

In the triangular branch module 100 made as described above, the triangular frame 10 may be a length selected according to the size of a tree-shaped solar cell module. In addition, the length of the triangular frame 10 may be selected depending on the strength of a material of the triangular frame 10.

It is apparent that the triangular frame 10 can be manufactured in predetermined length and thickness so that the triangular frame 10 can be installed in a structurally stable state capable of resisting strong wind and not too thin or thick as compared with the trunk module 200 to form a visually balanced tree-shaped solar cell module.

The size of the triangular frame 10 may be determined according to the sizes of solar cells. That is, the assembly space regions 12 of the triangular frame 10 may be sized according to the sizes of solar cells available in the market.

For example, if solar cells having a size of 156 mm x 156 mm or simple solar cell modules 22 having a width of 156 mm are used, the width of the assembly space regions 12 may be about 160 mm. In this case, the length between the neighboring corner 11 and jaw 13 of the triangular frame 10 may be about 20 mm, and the width of the triangular frame 10 from one corner 11 to the other corner 11 may be about 200 mm (160 mm + 20 mm + 20 mm). In this way, the size of the triangular frame 10 constituting the triangular branch module 100 may be determined.

The length of the triangular frame 10 may be determined according to the number of solar cells. For example, ten solar cells having a size of 156 mm x 156 mm are arranged in a row in each assembly space region 12 of the triangular frame 10 or are assembled into a simple solar cell module 22, the length of the triangular frame 10 may be about 1600 mm (1560 mm + the thick of the fixing plate 24).

That is, a manufacture can determine the length of the module 100 according to the number of solar cells 18 to be assembled.

An LED module having the same size as that of a simple solar cell module 22 may be attached to one of the assembly space regions 12 instead of the simple solar cell module 22.

In this case, the triangular branch module 100 may be attached to a tree-shaped solar cell module like a branch in a manner such that the assembly space region 12 to which the LED module is attached faces downward. Then, the tree-shaped solar cell module can be used like a streetlight by turning on the LED module at night.

Alternatively, a reflection module such as a glass mirror or a reflection film on which aluminum is deposited may be attached to one of the assembly space regions 12 instead of the LED module.

In this case, the module 100 may be attached to a tree-shaped solar cell module in a manner such that the assembly space region 12 on which the reflection module is attached faces downward. Then, light may be reflected from the reflection module to a simple solar cell module 22 attached to a lower triangular branch module 100 to increase the efficiency of solar power generation and reduce manufacturing costs.

Since the module end 23 of the triangular branch module 100 is a portion receiving much sunlight, a simple solar cell module 22 having a small size may be attached to the module end 23.

It is apparent that an LED module can be attached to the module end 23 instead of a simple solar cell module 22 to make the triangular branch module 100 easily recognized at night by turning on and off the LED module.

The wires 20 of the solar cells 18 or the simple solar cell modules 22 are arranged in the wire accommodation grooves 14 of the triangular branch module 100 and put in the internal cavity 16 through the penetration holes connecting the internal cavity 16 of the wire accommodation grooves 14. Then, ends of the wires 20 are pulled out through the wire hole 25 of the fixing plate 24 as connection wires 30, and the connection plug 31 is attached to the connection wires 30.

The connection plug 31 will be electrically connected to a connection socket 34 (described later) of the trunk module 200.

The triangular branch module 100 is a solar cell module shaped like a tree branch having no leaf so as not to be swung by wind. The thickness and length of the triangular branch module 100 is determined according to the size of a tree-shaped solar cell module to be made. That is, a small or large tree-shaped solar cell module can be made.

If a large tree-shaped solar cell module is made, twig modules (not shown) having designs and shapes similar to those of the triangular branch module 100 may be attached to the lateral sides of the triangular branch module 100 like twigs of a tree branch. However, such twig modules may be disadvantageous in terms of increasing wind influence, producing shadows, and increasing manufacturing costs. Therefore, after considering such disadvantages, the use of such twig modules may be determined.

Light receiving parts of the simple solar cell modules 22, that is, the outer sides of the transparent glass plates 19 may be finely uneven like lotus leaves or coated with a cleaning agent so that contaminants such as dust can be easily separated by self cleaning.

Such a finely uneven surface structure like lotus leaves or a cleaning agent for self cleaning is a technique known in the related art, and thus a detailed description thereof will be omitted.

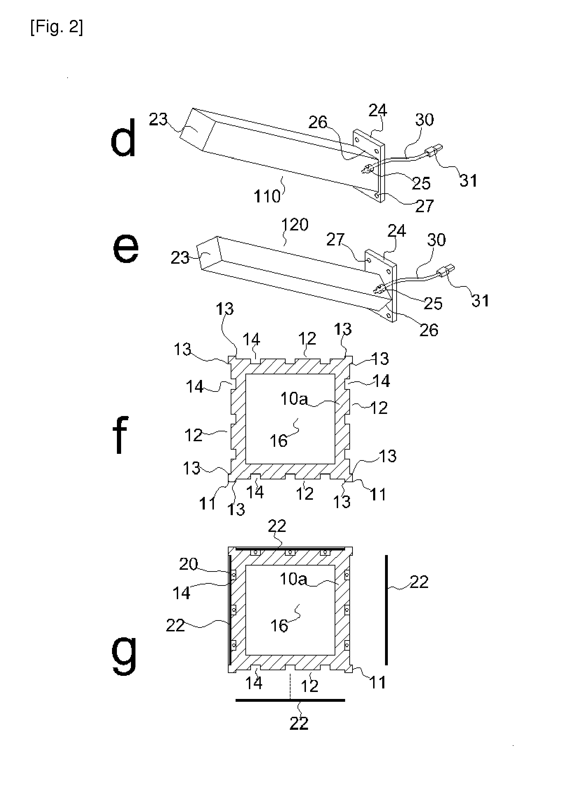

FIG. 2d is a perspective view showing a quadrangular branch module 110. The quadrangular branch module 110 is made in the same method as the triangular branch module 100 except for a quadrangular frame 10 corresponding to the triangular frame 10.

Referring to FIGS. 2d, 2e, 2f, and 2g, like in the triangular frame 10, assembly space regions 12 are formed by recessing the four sides of the quadrangular frame 10a to a depth of about 5 mm to 10 mm so as to attach solar cells thereto, and both sides of each corner 11 of the quadrangular frame 10a protrude as jaws 13 because of the relatively low assembly space regions 12. The jaws 13 protrude away from the assembly space regions 12.

Like the triangular frame 10, the quadrangular frame 10a includes an internal cavity 16, at least one wire accommodation groove 14 formed in each assembly space region 12 and having a depth toward the internal cavity 16, and penetration holes (not shown) regularly arranged in the length direction of the quadrangular frame 10a to connect the wire accommodation grooves 14 to the internal cavity 16.

A fixing plate 24 is provided on an end of the quadrangular frame 10a so that the triangular frame 10 can be fixed to the outside of a trunk module 200 (described later). According to the angle between the fixing plate 24 and a end fixing part 26 of the quadrangular frame 10a, the angle of the quadrangular frame 10a and the orientations of the four sides of the quadrangular frame 10a are determined.

That is, the quadrangular frame 10a can be positioned upward, horizontally, or downward from the position of the fixing part 26 according to the angle of the quadrangular frame 10a from the fixing plate 24 that will be vertically installed.

After the quadrangular branch module 110 including the quadrangular frame 10a is attached to the outside of the trunk module 200 (described later) like a tree branch, the quadrangular branch module 110 may be extend upward, horizontally, or downward from the trunk module 200 which is vertically installed like a tree trunk.

Referring to FIG. 2d, the fixing plate 24 having a quadrangular shape is fixed to the quadrangular frame 10a of the quadrangular branch module 110 with no twist angle with the quadrangular frame 10a. Therefore, when the quadrangular branch module 110 is attached to the trunk module 200, two of four simple solar cell modules 22 attached to opposite sides of the four sides of the quadrangular branch module 110 are located at upper and lower positions, that is, 0-degree and 180-degree positions, and the other two of the simple solar cell modules 22 are symmetrically located at left and right positions, that is, 90-degree and 180-degree positions.

FIG. 2e shows a rhombus branch module 120 in which a quadrangular frame 10a is fixed to a fixing plate 24 having a quadrangular shape with a twist angle of 45 degrees. Although the rhombus branch module 120 is assembled in the same method as the triangular branch module 100 and the quadrangular branch module 110, after the rhombus branch module 120 is attached to the trunk module 200, simple solar cell modules 22 are located at 45-degree, 135-degree, 225-degree, and 315-degree positions because the loading chambers 110a and the fixing plate 24 are fixed to each other with a twist angle of 45 degrees. If necessary, the quadrangular branch module 110 can be fixed to the fixing plate 24 with any twist angle from 0 to 360 degrees.

FIGS. 2f and 2g show how sheets 17, solar cells 18, and transparent glass plates 19, or simple solar cell modules 22 are attached to the assembly space regions 12 of the quadrangular frame 10a to form the quadrangular branch module 110 or the rhombus branch module 120. The assembly process is the same as that for the triangular branch module 100, and thus a detailed description thereof will be omitted.

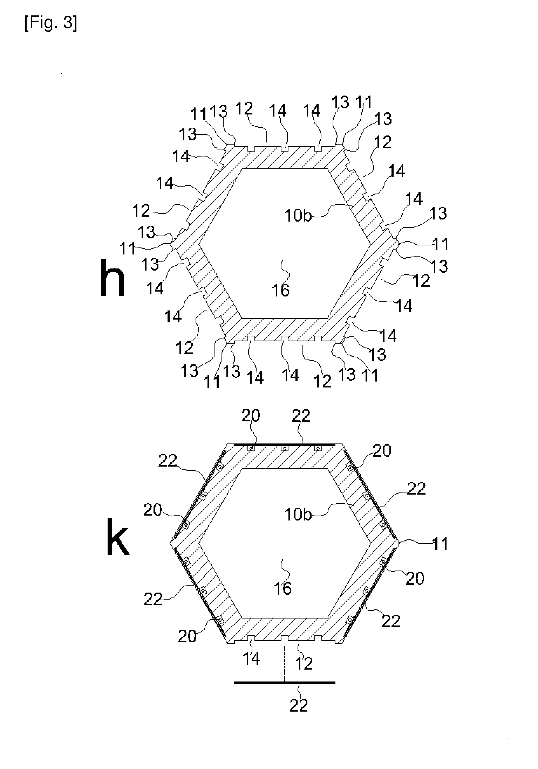

FIG. 3h shows a hexagonal frame 10b having the same structure as that of the triangular frame 10 or the quadrangular frame 10a except that the hexagonal frame 10b has a polygonal shape having more sides. The hexagonal frame 10b includes assembly space regions 12 on the six sides thereof, an internal cavity 16 therein, at least one wire accommodation groove 14 in each assembly space region 12, and penetration holes connecting the wire accommodation grooves 14 and the internal cavity 16.

Referring to FIG. 3k, like in the triangular frame 10 and the quadrangular frame 10a, sheets 17, solar cells 18, and transparent glass plates 19, or simple solar cell modules 22 are attached to the assembly space regions 12 of the hexagonal frame 10b to form a hexagonal branch module or hexagonal trunk module 200.

That is, as described above, a polygonal frame such as triangular, quadrangular, pentagonal, and hexagonal frames includes an assembly space region 12 on each side thereof, an internal cavity 16, at least one wire accommodation groove 14 in each assembly space region 12 for arranging wires, and penetration holes arranged regularly in the length direction thereof to connect the internal cavity 16 and the wire accommodation grooves 14. The polygonal frame can be used as a branch module or trunk module after attaching simple solar cell modules 22 to the polygonal frame.

A triangular frame or a quadrangular frame may be suitable for a branch module, and a pentagonal frame or a hexagonal frame may be suitable for a trunk module. The reason for this is that when the same solar cells are used, the circumference of a polygonal frame is determined whether the polygonal frame is a triangular frame, a quadrangular frame, or a hexagonal frame. That is, a polygonal frame having a large circumference is suitable for a trunk module rather than a branch module.

When it is intended to make a large tree-shaped solar cell module, a polygonal frame having many sides such as a pentagonal frame and a hexagonal frame may be used to form a branch module, and when it is intended to make a relative small tree-shaped solar cell module, a polygonal frame such as a triangular and a quadrangular frame may be used to forma a branch module. For example, if it is necessary to use a hexagonal branch module in a small tree-shaped solar cell module, small solar cells made of small wafers or solar cells made through an electrode printing process and a laser cutting process may be used.

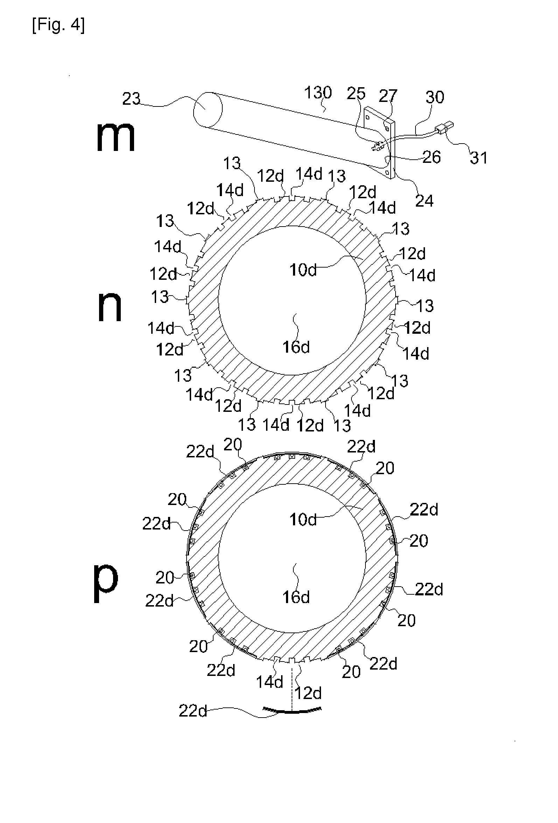

Referring to FIGS. 4m, 4n, and 4p, a long circular frame 10d includes: an internal cavity 16d; jaws 13 protruding at regular intervals from the outer side thereof; assembly space regions 12d formed between the jaws 13 and lower than the jaws 13 by about 5 mm to 10 mm, the assembly space regions 12d having a curvature like the long circular frame 10d; wire accommodation grooves 14d formed in the assembly space regions 12d toward the internal cavity 16d, and a plurality of penetration holes regularly arranged in the length direction of the long circular frame 10d to connect the wire accommodation grooves 14d and the internal cavity 16d.

According to the same method as described above, simple solar cell modules 22d are attached to the assembly space regions 12d of the circular frame 10d, and edges of the simple solar cell module 22d are fixed to the jaws 13 using any coupling method. The simple solar cell modules 22d have a curvature corresponding to that of the assembly space regions 12d for easy assembly.

The simple solar cell modules 22d are made of sheet solar cells and transparent glass plates having a curvature corresponding to that of the assembly space regions 12d.

A fixing plate 24 is fixed to an end of the circular frame 10d having a predetermined length, and the simple solar cell modules 22d are attached to the outer side of the circular frame 10d to form a circular branch module 130. The circular branch module 130 may be used as a branch module. Alternatively, the circular branch module 130 may be used as a trunk module 200 by installing the circular branch module 130 at an upright position using a fixing plate 81 (described later) instead of the fixing plate 24. The trunk module 200 will be described later in detail.

As described above, assembly space regions and wire accommodation grooves are formed on the outer side of such a polygonal frame as a triangular, quadrangular, pentagonal, hexagonal, or circular frame. Sheets, solar cells, and transparent glass plates, or simple solar cell modules are attached to the assembly space regions, and a waterproof adhesive is applied between the edges of the simple solar cell modules and jaws of the polygonal frame. Wires of the simple solar cell modules are arranged in the wire accommodation grooves and the internal cavity and are pulled out through a wire hole of a fixing plate attached to an end of the polygonal frame, and a connection plug 31 is attached to ends of the wires. In this way, a polygonal branch module can be made. If the polygonal branch module can be used as a trunk module by using a fixing plate 81 instead of the above-mentioned fixing plate to fix the module to the ground or floor.

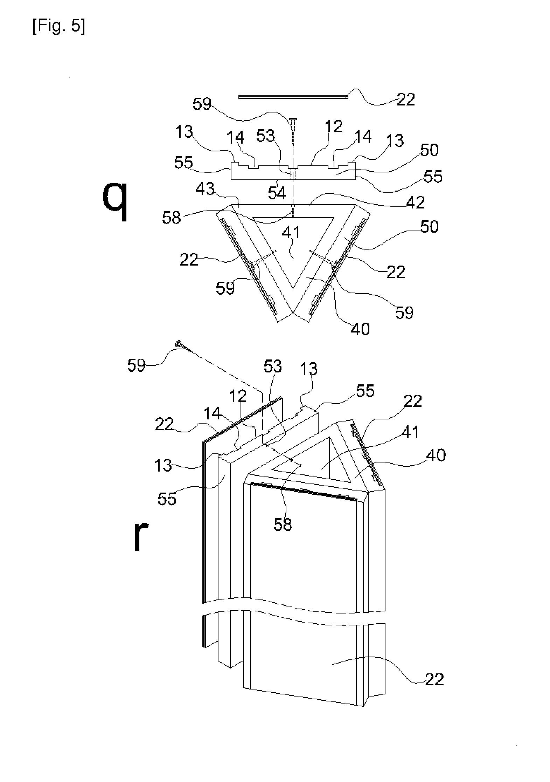

Another embodiment will now be described with reference to FIGS. 5q and 5r. Assembly space regions 12 and wire accommodation grooves 14 are not formed on three sides 42 of a triangular pillar 40 but a triangular internal space region 41 is formed in a center region of the triangular pillar 40. Screw holes 58 are formed in the three sides 42 of the triangular pillar 40 so that screws can be tightened toward the internal space region 41. Penetration holes (not shown) are formed from the sides 42 to the internal space region 41 so that when simple solar cell modules 22 are attached to the sides 42, wires of the simple solar cell modules 22 can be put into the internal space region 41 through the penetration holes.

The triangular pillar 40 may be formed of metal, wood, plastic, vinyl resins, or a ceramic material such as concrete. The length and size of the triangular pillar 40 can be selected according to the size of a solar cell branch or trunk module to be made using the triangular pillar 40.

In case of using the triangular pillar 40 to form a branch module, a fixing plate 24 is fixed to an end of the triangular pillar 40, and in case of using the triangular pillar 40 to form a trunk module, a fixing plate 81 is fixed to an end of the triangular pillar 40 to put the triangular pillar 40 at an upright position. Module auxiliary frames 50 to which simple solar cell modules 22 are attached are fixed to sides 42 of the triangular pillar 40.

The module auxiliary frames 50 are brought into contact with and applied to the sides 42 of the triangular pillar 40. The width of the module auxiliary frames 50, that is, the distance between ends 55 of the module auxiliary frames 50 is similar or equal to the width of the sides 42 so that the module auxiliary frames 50 can be easily attached to the sides 42. The length of the module auxiliary frames 50 is equal to the length of the triangular pillar 40, and the thickness of the module auxiliary frames 50 is about 10 mm to 20 mm. Back sides 54 of the module auxiliary frames 50 making contact with the sides 42 are flat, and assembly space regions 12 are formed by recessing front sides of the module auxiliary frames 50 toward the back sides 54. Wire accommodation grooves 14 are formed in the assembly space regions 12, and jaws 13 are formed on both sides of the assembly space regions 12. Ends of the jaws 13 correspond to the ends 55.

In the module auxiliary frames 50, the assembly space regions 12 are lower than the ends 55, and the jaws 13 are located inside the ends 55. The wire accommodation grooves 14 are formed in the length direction of the assembly space regions 12 to receive wires, and screw assembly holes 53 are formed in the wire accommodation grooves 14 toward the back sides 54. The screw assembly holes 53 are aligned with the screw holes 58 so that fixing screws 59 can be tightened therethrough.

The assembly space regions 12 of the module auxiliary frames 50 are provided to attach simple solar cell modules 22 to the assembly space regions 12. First, the back sides 54 of the module auxiliary frames 50 are brought into contact with the sides 42 of the triangular pillar 40, and fixing screws 59 are tightened in the screw assembly holes 53 of the module auxiliary frames 50 and the screw holes 58 of the triangular pillar 40 so as to fix the module auxiliary frames 50 to the sides 42 of the triangular pillar 40. Then, simple solar cell modules 22 are attached to the assembly space regions 12, and edges of the simple solar cell modules 22 are bonded to the jaws 13.

Passages such as penetration holes (not shown) are formed to connect the wire accommodation grooves 14 of the module auxiliary frames 50 to the internal space region 41 of the triangular pillar 40 so as to introduce wires of the simple solar cell modules 22 into the internal space region 41 of the triangular pillar 40 through the penetration holes.

Referring to FIGS. 5q and 5r, if the angle of each end 55 of the module auxiliary frames 50 is a right angle, the ends 55 do not form triangle vertices after the module auxiliary frames 50 are attached to the triangular pillar 40. This is the same when the triangular pillar 40 has any other polygonal shape such as triangular, pentagonal, and hexagonal shapes.

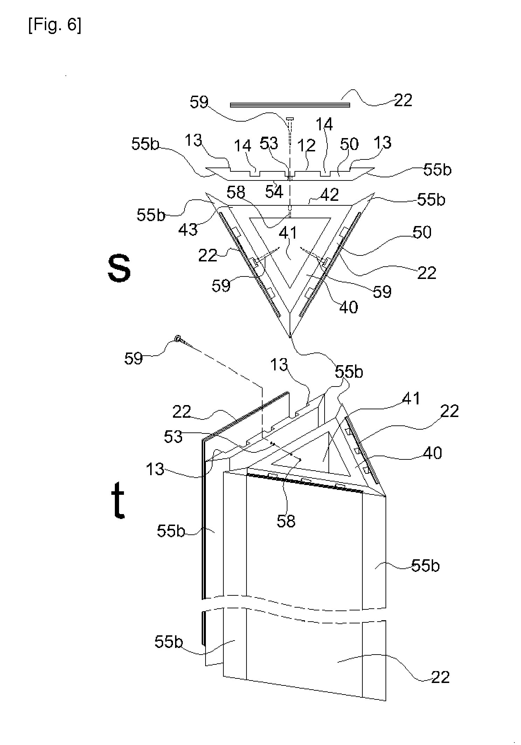

Referring to FIGS. 6s and 6t, unlike the above-described ends 55, ends 55b of module auxiliary frames 50 are not perpendicular to back sides 54 but angled according to the polygonal shape (triangular shape) of the triangular pillar 40. In the example, the ends 55b and the back sides 54 make an angle of 150 degrees so that the ends 55b are in contact with each other after the module auxiliary frames 50 are attached to the triangular pillar 40.

The triangular pillar 40 may have any other polygonal shape such as quadrangular, pentagonal, and hexagonal shapes. This will now be described.

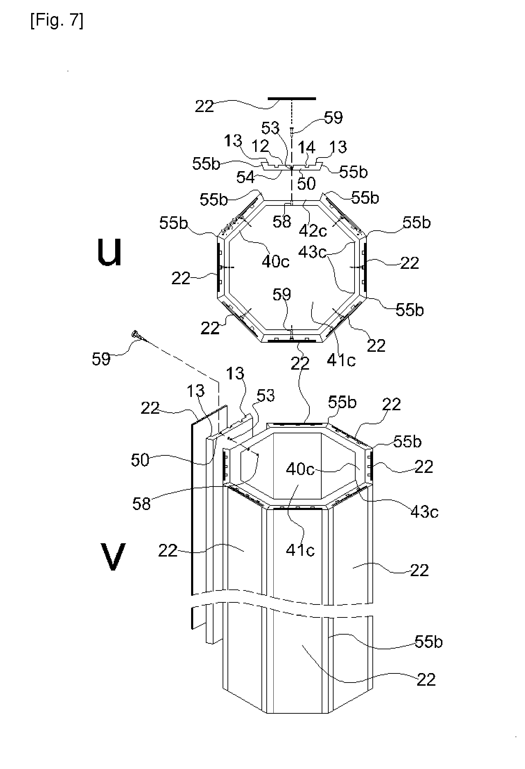

Referring to FIGS. 7u and 7v, an octagonal pillar 40c is shown. The angle between ends 55b and back sides 54 of module auxiliary frames 50 is determined applied to the shape of a polygonal pillar such as the octagonal pillar 40c. For example, the angle between the ends 55b and the back sides 54 is 150 degrees for a triangular pillar, 135 degrees for a quadrangular pillar, 126 degrees for a pentagonal pillar, 120 degrees for a hexagonal pillar, about 115 degrees for a heptagonal pillar, 112.5 degrees for an octagonal pillar, 110 degrees for a nonagonal pillar, and 108 degrees for a decagonal pillar.

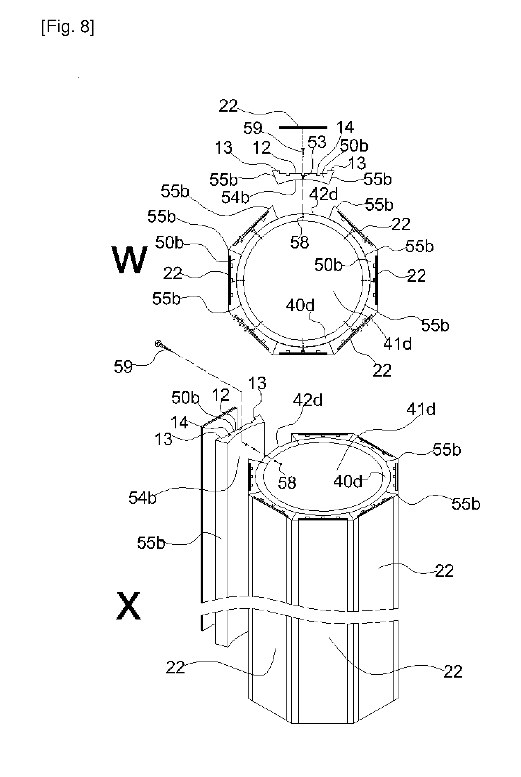

Referring to FIGS. 8w and 8x, a circular pillar 40d is shown. In this case, back sides 54b of module auxiliary frames 50b are shaped according to the circumference of the circular pillar 40d, that is, the circumference of an outer side 42b of the circular pillar 40d so that when the back sides 54b can be stably attached to the side 42b of the circular pillar 40d without any gap.

Although the circular pillar 40d is circular, since assembly space regions 12 and jaws 13 of the module auxiliary frames 50b are flat and stepped, flat simple solar cell modules 22 can be attached to the assembly space regions 12, and thus a polygonal shape can be obtained according to the number of the attached simple solar cell modules 22. Referring to FIGS. 8w and 8x, eight module auxiliary frames 50b are used to form an octagonal shape, and the simple solar cell modules 22 are attached to eight sides of the octagonal shape. Ends 55b of the module auxiliary frames 50b form the vertices of the octagonal shape. Therefore, an octagonal pillar can be formed.

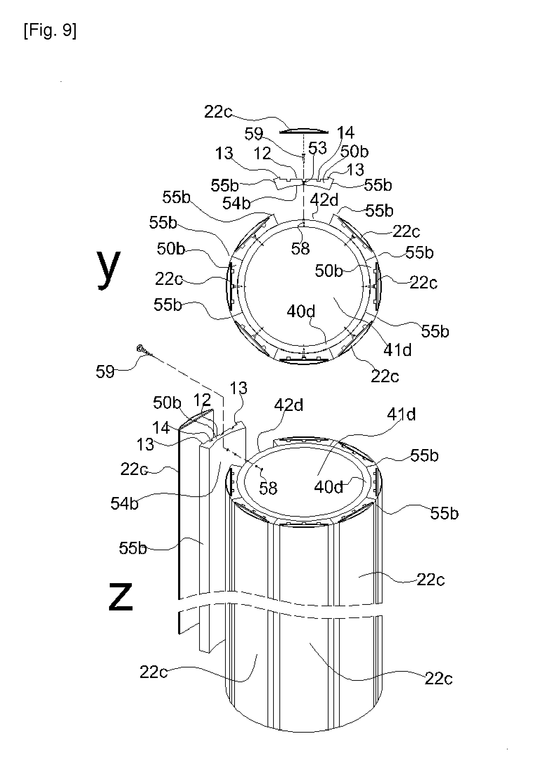

Referring to FIGS. 9y and 9z, a circular solar cell trunk module can be made using a circular pillar 40d. The outermost transparent plates of simple solar cell modules 22c attached to assembly space regions 12 of module auxiliary frames 50b are shaped in the form of a circular arc.

In the above description, the circular pillar 40d has the same diameter in the length direction thereof, that is, the same diameter at both ends thereof. However, if the circumference of the circular pillar 40d varies longitudinally because the circular pillar 40d has a large diameter at a lower end thereof and a relatively small diameter at an upper end thereof like a tapered utility pole, the width of the module auxiliary frames 50b may be varied in the length direction thereof according to the shape of the circular pillar 40d.

That is, the width of the module auxiliary frames 50b is increased as it goes upward. It is apparent that the difference between the lower-end width and upper-end width of the module auxiliary frames 50b is determined in proportion to the difference between the lower-end diameter and the upper-end diameter of the circular pillar 40d.

That is, if the circumference of the circular pillar 40d varies from the lower end to the upper end thereof like a tapered utility pole, the width of the module auxiliary frames 50b is also varied from the lower end to the upper end thereof according to the variation of the circumference of the circular pillar 40d.

As described above, the ends 55b of the module auxiliary frames 50b may be varied in size with an upwardly or downwardly increasing width, and accordingly the assembly space regions 12 may be varied in size with an upwardly or downwardly increasing width. In this case, it is apparent that simple solar cell modules 22, simple solar cell modules 22c, or sheets, solar cells, and transparent glass plates are varied in size according to the varying size of the assembly space regions 12.

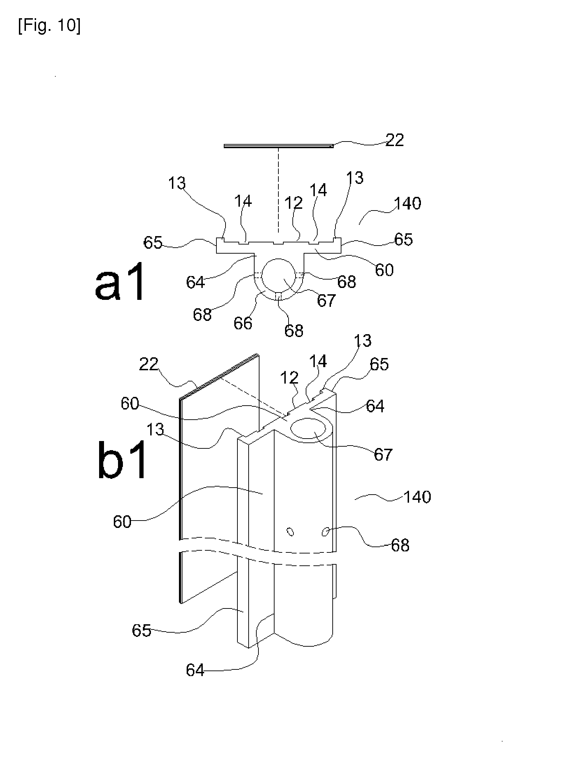

Another embodiment will now be described with reference to FIG. 10a1 showing a plan view of a branch module 140 and FIG. 10b1 showing a perspective view of the branch module 140. The branch module 140 includes a branch module single frame 60 having one assembly space region 12 to which one simple solar cell module 22 can be attached. That is, the branch module 140 will be used as a branch module but will not be used as a trunk module.

The thickness of the branch module single frame 60 may be about 10 mm to 20 mm. The width of the branch module single frame 60, that is, the distance between ends 65 of the branch module single frame 60 may be varied according to the size of a simple solar cell module 22 to be attached. Like in the case of the above-mentioned triangular frame 10, if the with of a simple solar cell module 22 to be attached is 156 mm, the width of the assembly space region 12 may be about 160 mm. In this case, if the distance between the jaws 13 and the ends 65 is 20 mm at one size, the with of the branch module single frame 60 may be about 200 mm (= 40 mm, the distances between the jaws 13 and the ends 65 at both sides, + 160 mm, the width of the assembly space region 12).

The length of the branch module single frame 60 is determined according to the number of solar cells included in the simple solar cell module 22 to be attached to the assembly space region 12. That is, a manufacture can determine the length of the branch module single frame 60.

At least one wire accommodation groove 14 is formed in the assembly space region 12 on the front side of the branch module single frame 60, and due to the jaws 13 inside the ends 65, the assembly space region 12 has a recessed shape. One-piece part 64 is formed on the back side of the branch module single frame 60, and a reinforcing frame 66 is formed in one piece with the one-piece part 64. The reinforcing frame 66 has a circular shape and extends in the length direction of the branch module single frame 60, and a circular internal space region 67 is formed in an center region of the reinforcing frame 66.

A plurality of penetration holes are formed from the outside of the branch module single frame 60 to the internal space region 67 so that when a simple solar cell module 22 is attached to the assembly space region 12, wires of the simple solar cell module 22 can be arranged, and bolt holes 68 are formed from the reinforcing frame 66 to the internal space region 67 so that when a fixing rod is inserted in the internal space region 67, the fixing rod can be fixing by inserting bolts in the bolt holes 68 and tightening the bolts.

The branch module 140 is provided after a simple solar cell module 22 is attached to the assembly space region 12 of the branch module single frame 60 as described above.

When the branch module 140 is used, a fixing rod is inserted in the internal space region 67 of the branch module 140, and the branch module 140 is fixed by tightening bolts through the bolt holes 68 in a state where the simple solar cell module 22 attached to the assembly space region 12 is oriented upward.

The fixing rod inserted in the internal space region 67 of the reinforcing frame 66 of the branch module 140 is a rod previously fixed to the outside of a pillar. That is, a tree-shaped solar cell module can be made by inserting the fixing rod in the internal space region 67 of the branch module 140 and tightening bolts through the bolt holes 68.

In detail, a tree-shaped solar cell module can be provided by attaching fixing rods to the outside of a tree-shaped pillar like branches and coupling such branch modules 140 to the fixing rods.

Although the reinforcing frame 66 and the internal space region 67 are circular in the above description, the reinforcing frame 66 and the internal space region 67 may have a polygonal shape. In this case, a fixing rod to be inserted in the internal space region 67 may also have a circular shape or a polygonal shape corresponding to the shape of the internal space region 67.

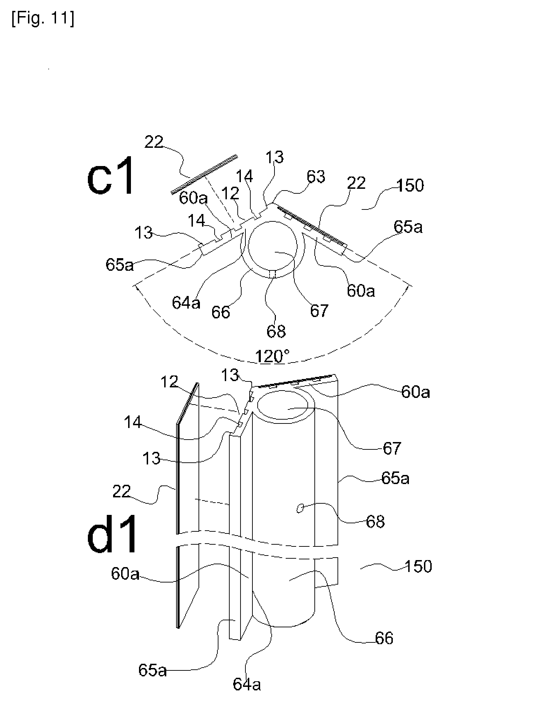

FIG. 11c1 is a plan view showing a branch module 150, and FIG. 11d1 is a perspective view showing the branch module 150. The branch module 150 is a modified version of the branch module 140. The branch module 150 includes a branch module dual frame 60a so that two simple solar cell modules 22 can be attached for one reinforcing frame 66. The branch module dual frame 60a includes two assembly space regions 12 to which simple solar cell modules 22 can be attached. At a corner 63, two jaws 13 makes an angle of 120 degrees like two branch module frames 60 are connected.

In other words, the branch module dual frame 60a includes two branch module frames 60 connected at an angle of 120 degrees. It is apparent that the angle between the two branch module frames 60 can have any other value smaller than or greater than 120 degrees.

The branch module dual frame 60a includes the two assembly space regions 12 and has an angle of 120 degrees at the corner 63 between the two assembly space regions 12. A reinforcing frame 66 including an internal space region 67 protrudes from a one-piece part 64 of the back side of the branch module dual frame 60a. The reinforcing frame 66 is parallel with the assembly space regions 12 and has the same length as that of the assembly space regions 12. In the branch module dual frame 60a, wire holes are formed from the assembly space regions 12 to the internal space region 67, and a plurality of bolt holes 68 are formed so that the branch module 150 can be used in the same manner as that for the branch module 140.

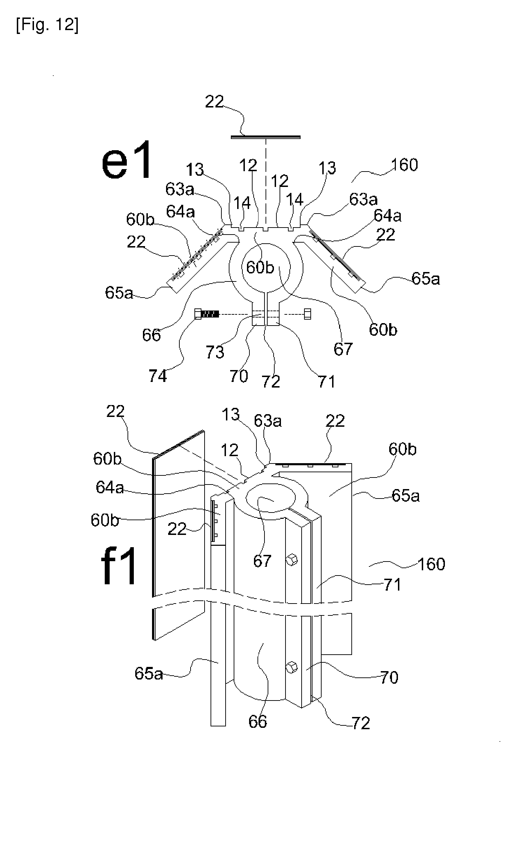

FIG. 12e1 is a plan view showing a branch module 160, and FIG. 12f1 is a perspective view showing the branch module 160. The branch module 160 includes a branch module multiple frame 60b having three assembly space regions 12 to which simple solar cell modules 22 can be attached. The branch module multiple frame 60b is a combined version of the branch module single frame 60 and the branch module dual frame 60a. In other words, the branch module multiple frame 60b includes three branch module frames 60 that are connected to each other and has an angle of 135 degrees at each corner 63a. That is, that angle between the assembly space regions 12 of the branch module multiple frame 60b are 135 degrees.

A reinforcing frame 66 protrudes from a middle portion (one-piece part 64a) of the branch module multiple frame 60b. The reinforcing frame 66 is formed in one piece with the branch module multiple frame 60b in the length direction of the branch module multiple frame 60b. An internal space region 67 is formed in a center portion of the reinforcing frame 66, and a gap 72 is formed in the length direction of the reinforcing frame 66 to open the internal space region 67. Fixing taps 70 and 71 protrude from both sides of the gap 72 as fixing structures. A plurality of fixing bolt holes 73 are formed through sides of the fixing taps 70 and 71 so that if the fixing taps 70 and 71 are fastened by inserting fixing bolts 74 in the fixing bolt holes 73 and tightening the fixing bolts 74 and nuts, the internal space region 67 can be shrunk by the width of the gap 72 between the fixing taps 70 and 71 to fix a circular fixing rod inserted in the internal space region 67.

After simple solar cell modules 22 are attached to the assembly space regions 12 of the branch module dual frame 60a, the branch module 160 can be used as a branch module of a tree-shaped solar cell module.

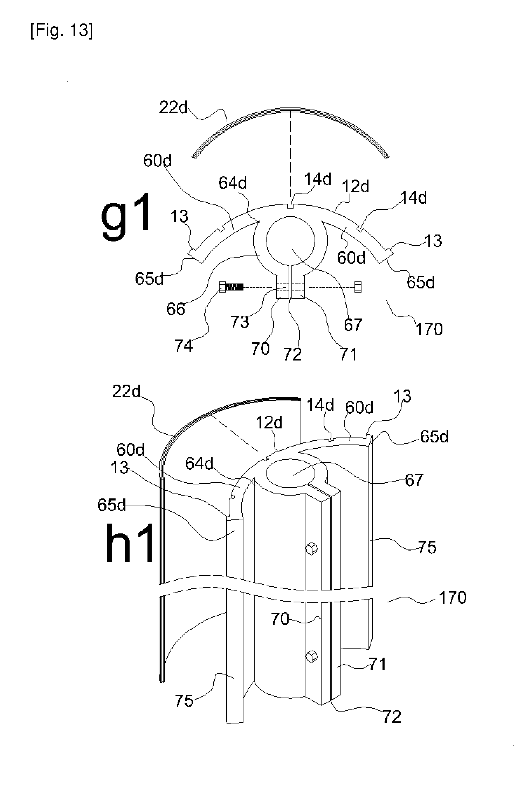

FIG. 13g1 is a plan view showing a branch module 170, and FIG. 13h1 is a perspective view showing the branch module 170. The branch module 170 includes a branch module curve frame 60d, and the branch module curve frame 60d includes a assembly space region 12 having an arc shape. A plurality of wire accommodation grooves 14 are formed in the assembly space region 12d, and jaws 13 and ends 65d are higher than the assembly space region 12d.

A reinforcing frame 66 extends from a one-piece part 64d formed on an arc-shaped middle portion of the back side of the branch module curve frame 60d, The reinforcing frame 66 is formed in one piece with the one-piece part 64d and has the same length as the one-piece part 64d. An internal space region 67 is formed in the reinforcing frame 66 in the length direction of the reinforcing frame 66.

A gap 72 is formed in a portion of the reinforcing frame 66 to open the internal space region 67, and fixing taps 70 and 71 are formed on both sides of the gap 72. A plurality of fixing bolt holes 73 are regularly formed in sides of the fixing taps 70 and 71, and thus the fixing taps 70 and 71 can be fastened by tightening fixing bolts 74 in the fixing bolt holes 73 to firmly fix a circular rod inserted in the internal space region 67. That is, the internal space region 67 can be shrunk by the width of the gap 72 to fix a circular rod inserted in the internal space region 67.

A simple solar cell module 22d to be attached to the assembly space region 12d of the branch module curve frame 60d may have an arc shape corresponding to the arc shape of the assembly space region 12d. For this, the simple solar cell module 22d may include thin-film solar cells, or the simple solar cell modules 22d may include crystalline solar cells which are formed of an arc-shaped wafer or are cut into small sizes by a cutting process.

The above-described branch modules and trunk modules may have a long length. In this case, the branch modules and the trunk modules may be straight or gradually curved in the length direction thereof so that a tree-shaped solar cell module having a straight shape or a freely curved shape can be made.

In addition, the branch modules and the trunk modules may be slightly twisted or may be slightly curved and twisted.

Straight branch modules and trunk modules may be used to form solar cell modules for industrial solar power generation, and slightly curved or twisted branch modules and trunk modules may be used to form solar cell modules shaped like landscaping trees for solar power generation harmonized with environments of downtown areas or residential areas.

An explanation will not be given about installation of the branch modules and trunk modules described with reference to FIGS. 1 to 13.

Simple solar cell modules 22 are attached to the assembly space regions 12 or the assembly space regions 12d of the above-described polygonal frame such as the triangular frame 10, the quadrangular frame 10a, the hexagonal frame 10b, the octagonal frame 10c, and the circular frame 10, and the polygonal pillar such as the triangular pillar 40, the quadrangular pillar 40b, the octagonal pillar 40c, and the circular pillar 40d. As described above, if the fixing plate 24 is provided on an end of the polygonal frame or the polygonal pillar, the polygonal frame or pillar is used as a branch module, and if the fixing plate 81 is provided on an end of the polygonal frame or pillar, the polygonal frame or pillar is used as a trunk module.

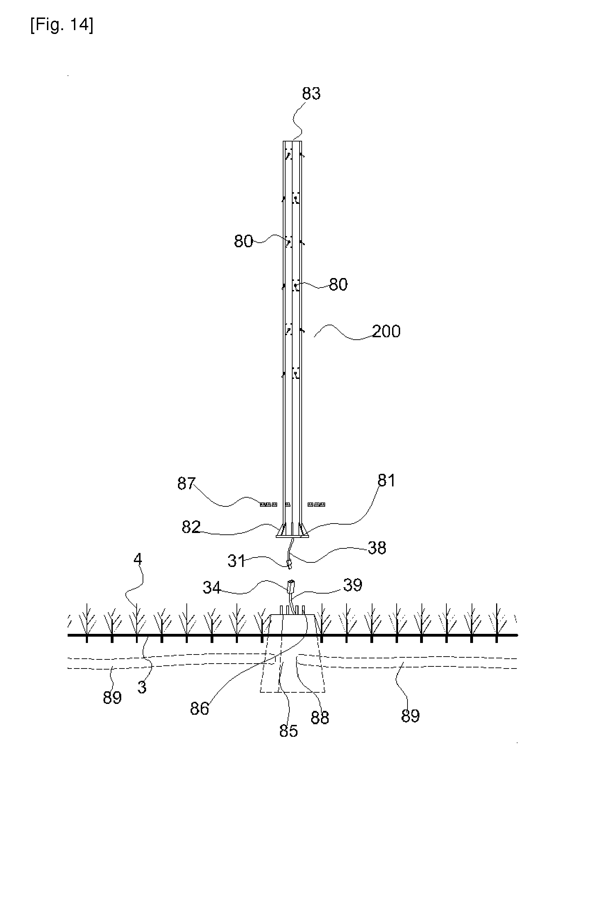

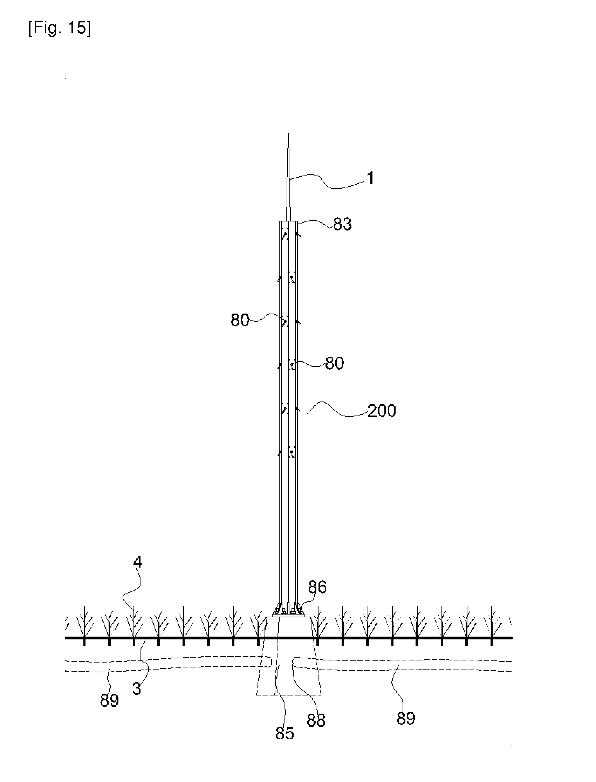

The trunk module 200 will now be described in more detail with reference to FIGS. 14 to 16. The fixing plate 81 is provided on an end of the trunk module 200, and a plurality of reinforcing plates 82 are used to support the fixing plate 81 and the trunk module 200. Bolt holes are formed between the reinforcing plates 82.

For fixing branch modules to the trunk module 200, nut holes 84 are formed in the trunk module 200 at positions corresponding to the fixing holes 27 of the fixing plates 24 of the branch modules.

Connection wires 33 are provided at wire holes 80, and connection sockets 34 are provided on ends of the connection wires 33. The connection wires 33 are electrically connected in parallel or series to a main wire 38 accommodated in the internal cavity 16, the internal cavity 16d, the internal space region 41, the internal space region 41b, the internal space region 41c, or the internal space region 41d of the trunk module 200. The main wire 38 may be pulled out to a lower side of the fixing plate 81, and a connection plug 31 is provided on an end of the main wire 38.

Since the trunk module 200 may be formed of a polygonal branch module or trunk module such as the triangular branch module 100, the quadrangular branch module 110, the rhombus branch module 120, and the circular branch module 130, the internal space of the trunk module 200 may be the internal cavity 16, the internal cavity 16d, the internal space region 41, the internal space region 41b, the internal space region 41 c, or the internal space region 41d.

A base 85 is supported in the ground by burying a lower portion of the base 85 in the ground surface layer 90. The top surface of the base 85 is horizontal, and fixing bolts corresponding to bolt holes of the fixing plate 81 are disposed on the top surface of the base 85. A connection wire 39 and a connection socket 34 are connected to a wire 89 buried in the ground. The wire 89 is connected to a controller such as a load-side inverter.

The connection plug 31 is connected to the connection socket 34, and the fixing plate 81 of the trunk module 200 is placed on the fixing bolts 86 of the base 85. Then, nuts are tightened to the fixing bolts 86. In this way, the trunk module 200 can be installed.

Hereinafter, an explanation will now be given about a typical case where a tree-shaped solar cell module 400 is configured by a trunk module 200 and rhombus branch modules 120.

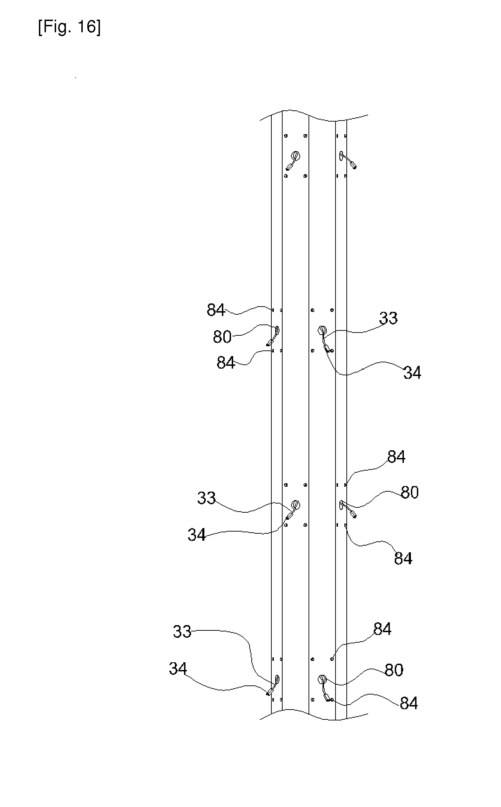

Referring to FIGS. 16 to 18, the trunk module 200 includes the connection sockets 34 and the connection wires 33 for electric connection with wires of solar cells. Therefore, when the fixing plates 24 of the rhombus branch modules 120 are attached to the nut holes 84 of the trunk module 200, the connection plugs 31 of the rhombus branch modules 120 are first connected to the connection sockets 34 of the trunk module 200, and the connection plugs 31 and the connection sockets 34 are put inward through the wire holes 80 of the trunk module 200. Then, the fixing holes 27 of the fixing plates 24 of the rhombus branch modules 120 are aligned with the nut holes 84, the rhombus branch modules 120 are fixed to the trunk module 200 by tightening bolts through the fixing holes 27 and the nut holes 84. In this way, the tree-shaped solar cell module 400 are assembled.

When the rhombus branch modules 120 are fixed to the nut holes 84 of the trunk module 200, an adhesive (not shown) such as a silicone adhesive may be applied therebetween or o-rings may be disposed therebetween for sealing therebetween. Then, water may not permeate through the wire holes 80 and the nut holes 84 of the trunk module 200 and the wire hole 25 of the rhombus branch modules 120.

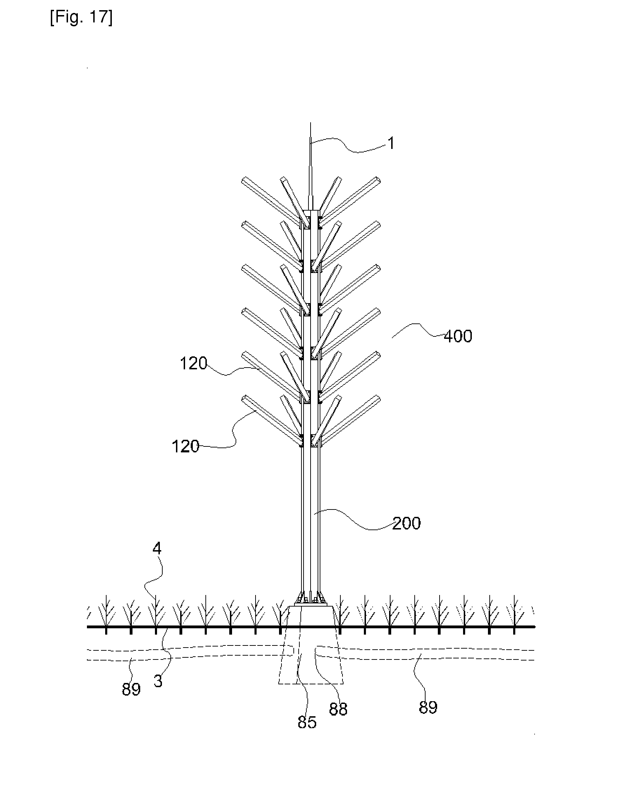

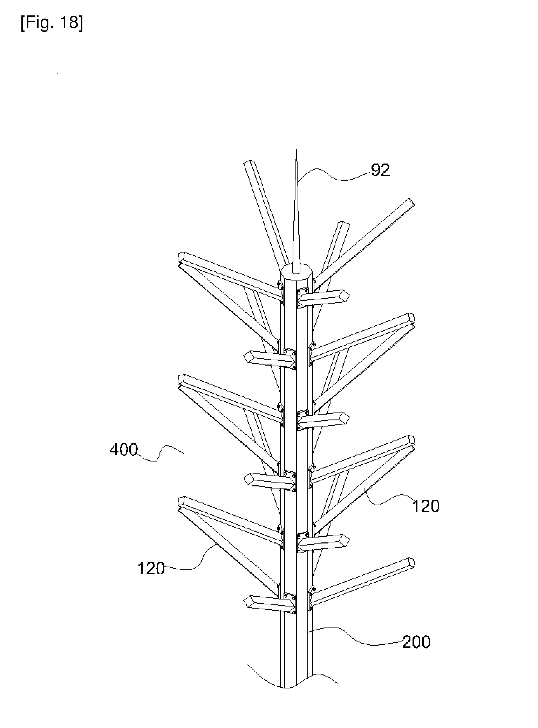

FIG. 16 is an enlarge view showing the trunk module 200, FIG. 17 is a front view showing the tree-shaped solar cell module 400 after installation, and FIG. 18 is an enlarged perspective view showing the rhombus branch modules 120 of the tree-shaped solar cell module 400.

The tree-shaped solar cell module 400 may be provided by attaching branch modules such as triangular branch modules 100, quadrangular branch modules 110, or rhombus branch modules 120 to the outside of the trunk module 200 like tree branches. The tree-shaped solar cell module 400 may include triangular branch modules 100, quadrangular branch modules 110, or rhombus branch modules 120, or the tree-shaped solar cell module 400 includes combinations thereof.

Referring to FIGS. 17 and 18, in the tree-shaped solar cell module 400, rhombus branch modules 120 of one layer are staggered with rhombus branch modules 120 of the next layer. That is, layers of the rhombus branch modules 120 or upper and lower layers of the rhombus branch modules 120 are staggered so as to be evenly exposed to sunlight.

Twig modules (not shown) similar or equal to the rhombus branch modules 120 may be attached to lateral sides of the rhombus branch modules 120 like tree twigs. In this case, the rhombus branch modules 120 may be easily swung by wind, and the power generation efficiency of the rhombus branch modules 120 and the trunk module 200 may be decreased because of shadows of the twig modules. In addition, the effect of power generation by the twig modules may be low as compared with the manufacturing costs thereof. Therefore, such twig modules may be used for the purpose of landscaping or the like.

For example, the tree-shaped solar cell module 400 can be installed at a desired place by digging the ground using a screw drill machine or excavator and burying a lower portion of the trunk module 200 in the ground.

In another example, after digging the ground as described above, a base 85 is partially buried in the ground, and the fixing plate 81 provided on the lower end of the trunk module 200 is placed on the base 85. Then, the fixing plate 81 is fixed to the base 85 using bolts 86 and nuts 87. Thereafter, the connection plugs 31 of the rhombus branch modules 120 are electrically connected to the connection sockets 34 of the trunk module 200, and then after aligning the fixing holes 27 with the nut holes 84, the rhombus branch modules 120 are fixed to the trunk module 200 using bolts.

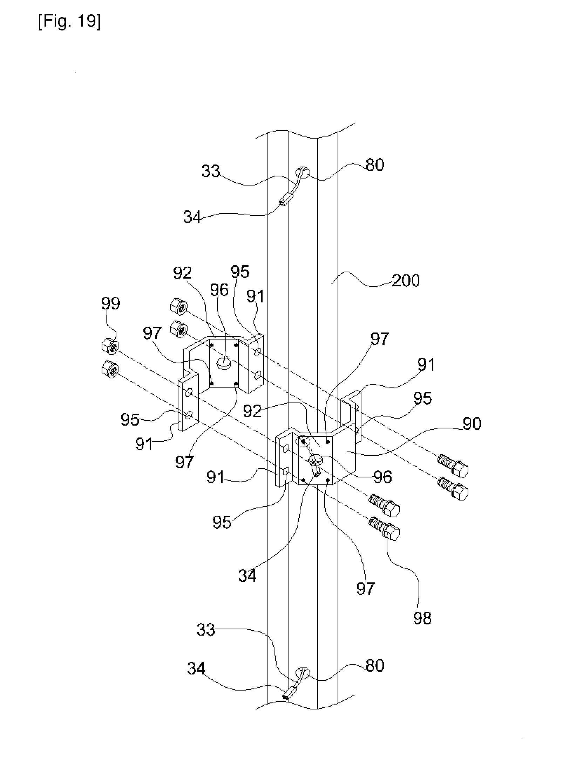

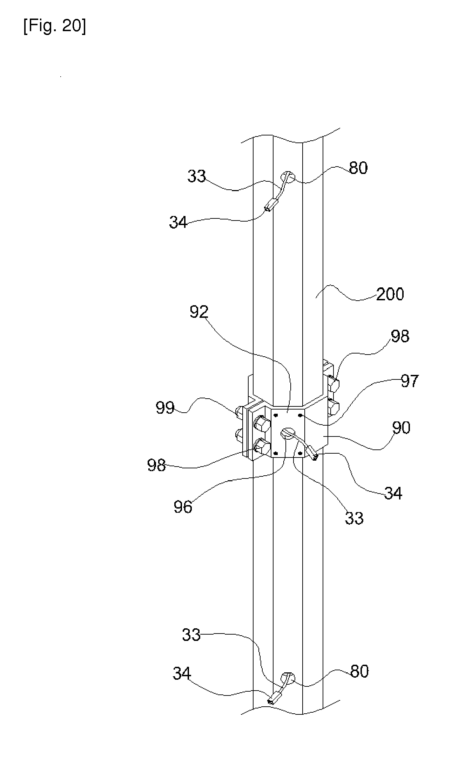

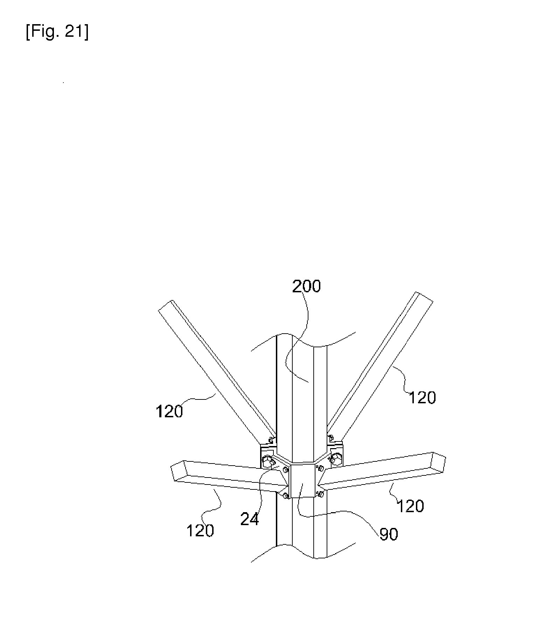

FIGS. 19, 20, and 21 show the case where rhombus branch modules 120 are fixed to a trunk module 200 using branch coupling parts 90. The branch coupling parts 90 are used if it is difficult to form the nut holes 84 or the nut holes 84 are weak for attaching the rhombus branch modules 120. In addition, the branch coupling parts 90 may be used when attaching rhombus branch modules 120 to a pillar instead of the trunk module 200.

The branch coupling parts 90 are used in pairs, and the shape of the branch coupling parts 90 are different according to the shape of the trunk module 200. An exemplary case where the trunk module 200 has a octagonal shape an the branch coupling parts 90 have a corresponding shape will now be explained. It is apparent that proper branch coupling parts 90 can be selected according to the shape of the trunk module 200 such as a circular shape and whether the lower end and upper end of the trunk module 200 is different or not.

Two or three branch coupling parts 90 may be used as a set around the trunk module 200. In the exemplary case, two branch coupling parts 90 are used as a set.

In the case where the two branch coupling parts 90 are coupled to the trunk module 200 having an octagonal shape, the set of the two coupling parts 90 has an octagonal shape. That is, each of the branch coupling parts 90 has a half of the octagonal shape. In detail, each of the branch coupling parts 90 has a complete three sides and two half sides on both ends thereof, and coupling plates 91 protrude laterally from both ends of the branch coupling parts 90. The coupling plates 91 are formed in one piece with the branch coupling parts 90, and at least of coupling hole 95 is formed in each coupling plate 91. When the branch coupling parts 90 are coupled, the coupling plates 91 are aligned.

The sides of the branch coupling parts 90 will now be referred to as connection portions 92, and a wire hole 96 is formed in each connection portion 92 so that a connection socket 34 can be inserted. A plurality of nut holes 97 are formed around the wire hole 96 so that the fixing plate 24 of a rhombus branch module 120 or any other branch module can be fixed to the nut holes 97. The nut holes 97 are positioned so that the nut holes 97 can be aligned with the fixing holes 27 of the fixing plate 24 for inserting bolts therein.

If the trunk module 200 has a circular shape, it is apparent that the branch coupling parts 90 have a semicircular shape, and the number of the wire holes 96 and the nut holes 97 are determined according to the number of branch modules to be attached to the branch coupling parts 90. That is, according to the shape of the trunk module 200, branch coupling parts 90 having proper shapes such as semi polygonal shapes may be used.

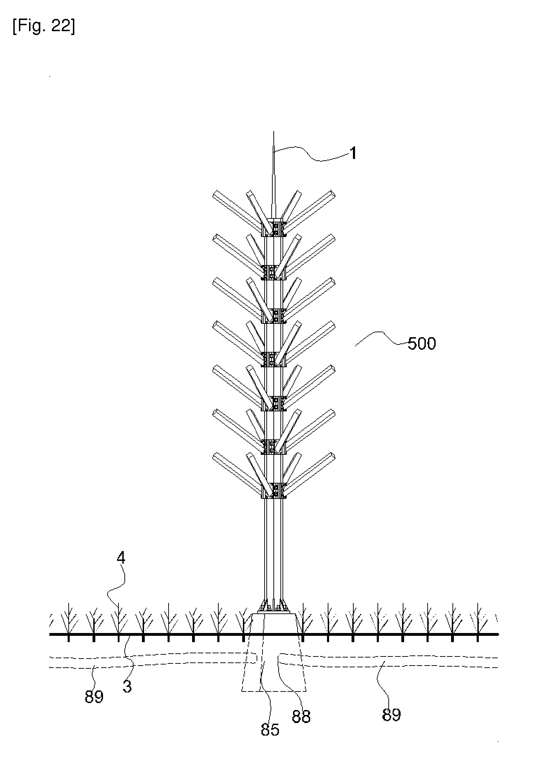

Referring to FIG. 22, branch coupling parts 90 are coupled in pairs around a trunk module 200, and coupling plates 91 of the branch coupling parts 90 are fastened by inserting coupling bolts 98 in coupling holes 95 and tightening the coupling bolts 98 with coupling nuts 99. In this way, a tree-shaped solar cell module 500 is assembled.

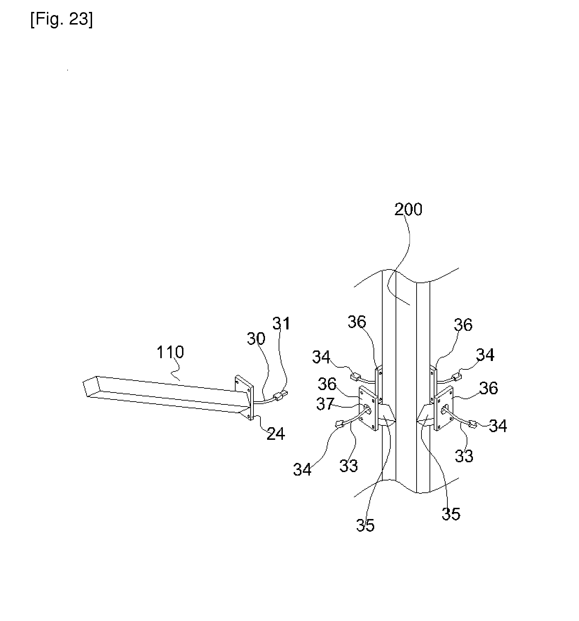

Referring to FIG. 23, a trunk module 200 includes a one-piece supports 35 and fixing plates 36 for attaching branch modules such as quadrangular branch modules 110 to the trunk module 200. The one-piece supports 35 and the fixing plates 36 are arranged on the outer side of the trunk module 200 so that quadrangular branch modules 110 can be attached thereto.

The one-piece supports 35 may have a polygonal shape or circular shape. The one-piece supports 35 may be oriented in predetermined directions in which the quadrangular branch modules 110 will be attached. The fixing plates 36 have a rectangular shape in the drawing. However, the fixing plates 36 have any other polygonal shape or a circular shape.

If the trunk module 200 is formed of a metal, the one-piece supports 35 and the fixing plates 36 may be formed of a metal and fixed to the trunk module 200 by welding.

If the trunk module 200 is formed of concrete and steel reinforcing bars, the one-piece supports 35 formed of a metal may be welded to the reinforcing bars, and then concrete may be introduced into a mould to form the trunk module 200 with the one-piece supports 35 and the fixing plates 36.

Wire holes 37 are in the front sides of the fixing plates 36. The wires holes 37 are connected to an inner space of the trunk module 200 through an inner space of the one-piece supports 35. Connection wires 33 to which connection sockets 34 are attached are pulled out through the wire holes 37.

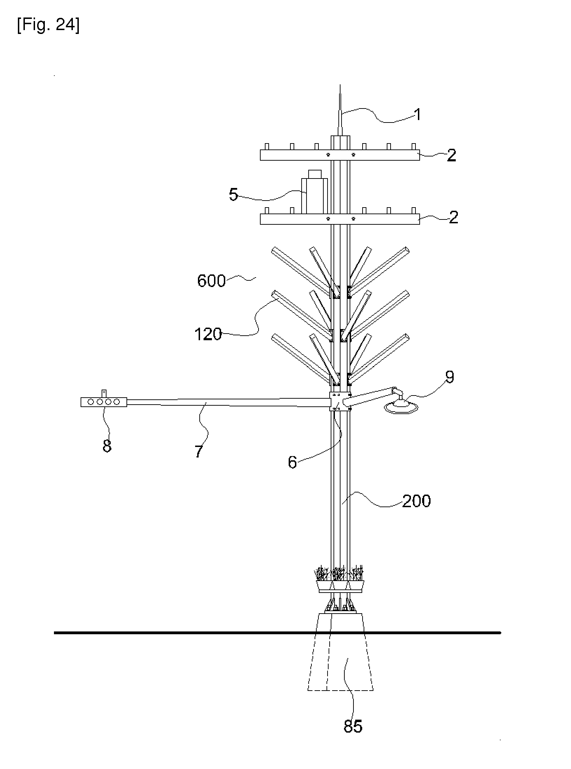

As shown in FIG. 24, equipment such as street facilities may be installed on a tree-shaped solar cell module of the present invention. In the drawings, a lightening rod 1, utility pole crossarms 2, a transformer, a traffic lights 8, and a streetlamp 9 are installed on an upper portion of a trunk module 200 of a tree-shaped solar cell module 600. In addition, flowerpots may be disposed around the lower end of the trunk module 200.

In other words, the tree-shaped solar cell module 600 is provided by adding a lightening rod 1, utility pole crossarms 2, a transformer, traffic lights 8, and a streetlamp 9 to the upper portion of the trunk module 200 of the tree-shaped solar cell module 400, and disposing flowerpots around the lower end of the trunk module 200.

Since the utility pole crossarms 2 also called metal arms, steel arms, or iron shoulders are fixed to an upper portion of the trunk module 200 of the tree-shaped solar cell module 600, electric wires can be supported by the tree-shaped solar cell module 600, and thus the tree-shaped solar cell module 600 can be used as a utility pole on a street as well as being used for solar power generation.

The tree-shaped solar cell module 600 can be installed on a place where a utility pole is not installed, and electricity generated by the tree-shaped solar cell module 600 can be supplied to electricity equipment of an electric power company so that costs necessary to install a utility pole can be saved. Electricity generated from sunlight by the tree-shaped solar cell module 600 can be converted into AC power using an inverter and boosted in voltage using the transformer, and then the AC power can be transmitted through electric wires supported on the crossarms 2.

For the purpose of solar power generation of the present invention, solar cells may be attached to the crossarms 2 or a traffic light support bar 7 in the same method as that used to attach solar cells to the quadrangular branch modules 110.

The traffic light support bar 7 may be fixed to the trunk module 200 using a traffic light coupling part 6 at a height of about 5 mm to about 7 mm from the ground which is the height where traffic lights are installed, and the traffic lights 8 may be attached to an end of the traffic light support bar 7.

As described above, the tree-shaped solar cell module 600 can be installed on a street and used as a street tree, a utility pole, and traffic lights as well as being used for solar power generation. In addition, other structures such as a load sign, a unmanned camera, and the streetlamp 9 can be attached to the tree-shaped solar cell module 600.

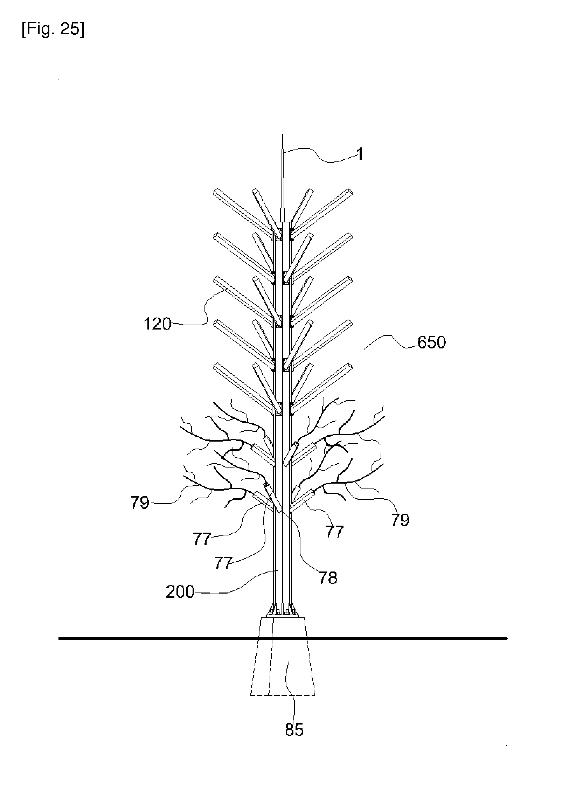

FIG. 25 is a view showing a tree-shaped solar cell module 650 in which flowerpots 77 having internal cavities are fixed to a trunk module 200 at a height of about 3 m to about 5 m from the ground to put roots of trees in the flowerpots 77. That is, the tree-shaped solar cell module 650 can used for planting and power generation. This will now be described in more detail.

Small trees may be planted in the flowerpots 77. The flowerpots 77 are oriented upward so that the internal cavities of the flowerpots 77 can be open upward, and fixing parts 78 of the flowerpots 77 may be fixed to the trunk module 200 by welding or using bolts. The internal cavities may be filled with soil, humus, ceramic powder, or the like for planting trees.

The flowerpots 77 may have a circular shape or a polygonal shape and formed of a material such as metals, ceramic materials, and plastics.

Like actual branches of a tree, the flowerpots 77 may be fixed to the trunk module 200 at angles of 0 to 180 degrees with respect to the trunk module 200.

Owing to alive trees planted in the flowerpots 77 fixed to the trunk module 200, the tree-shaped solar cell module 650 can appear like a street tree.

If the tree-shaped solar cell module 650 is installed on a street, people can see trees planted in the flowerpots 77, and electricity can be generated from solar cells of upper rhombus branch modules 120 of the tree-shaped solar cell module 650.

Although not shown in the drawing, so as to provide environments where the trees planted in the flowerpots 77 can grow well, penetration holes are formed in center portions of the fixing parts 78 to connect the internal cavities of the flowerpots 77 to an internal cavity of the trunk module 200, and bundles of fine tubes such as capillary tubes are inserted in the penetration holes in a manner such that the upper ends of the capillary tube bundles are placed at the lower ends of the internal cavities of the flowerpots 77 and the lower ends of the capillary tube bundles are pulled outward through the lower end of the internal cavity of the trunk module 200.

When the tree-shaped solar cell module 650 is installed, the lower ends of the capillary tube bundles pulled outward through the lower end of the trunk module 200 are deeply buried in the ground so that water can be pulled upward from the ground to the trees planted in the flowerpots 77 through the capillary tube bundles.

The capillary tube bundles each having fine tubes may be formed of a material such as stainless metals, ceramic materials such as glass, plastics, and vinyl resins.

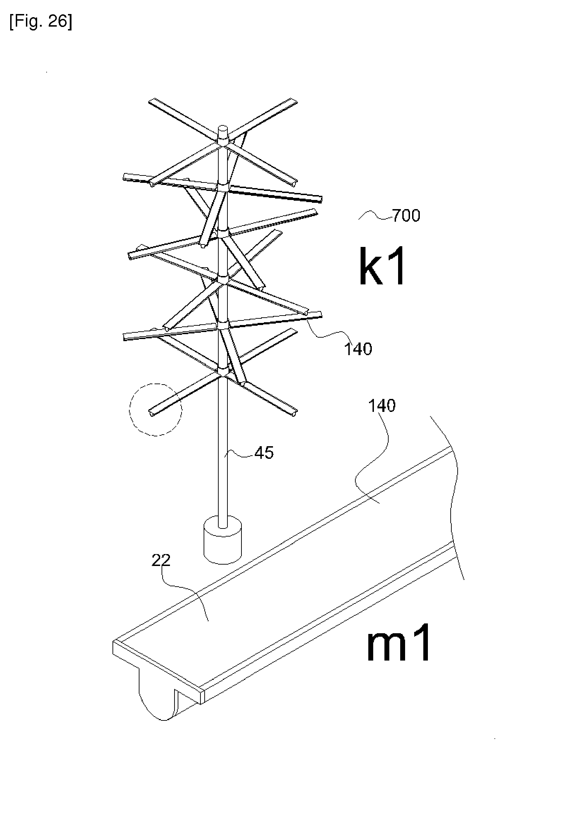

FIG. 26k1 is a perspective view showing a tree-shaped solar cell module 700, and FIG. 26ml is an enlarged view showing a portion of a branch module 140. In the tree-shaped solar cell module 700, the above-described branch modules 140 are fixed to a pillar 45. The pillar 45 may be a metal pillar such as an iron pillar or a concrete pillar. Support rods fixed to the pillar 45 are inserted in internal space regions 67 of the branch modules 140 and are fixed using bolts. In this way, the tree-shaped solar cell module 700 can be assembled and used for solar power generation.

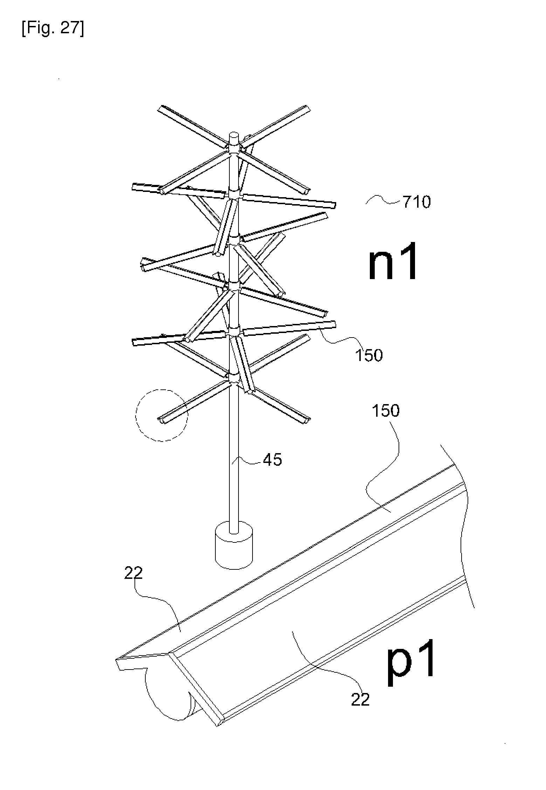

FIG. 27n1 is a perspective view showing a tree-shaped solar cell module 710, and FIG. 27p1 is an enlarged view showing a portion of a branch module 150. In the tree-shaped solar cell module 710, the above-described branch modules 150 are fixed to a pillar 45. Support rods fixed to the pillar 45 are inserted in internal space regions 67 of the branch modules 150 and are fixed using bolts. In this way, the tree-shaped solar cell module 710 can be assembled and used for solar power generation.

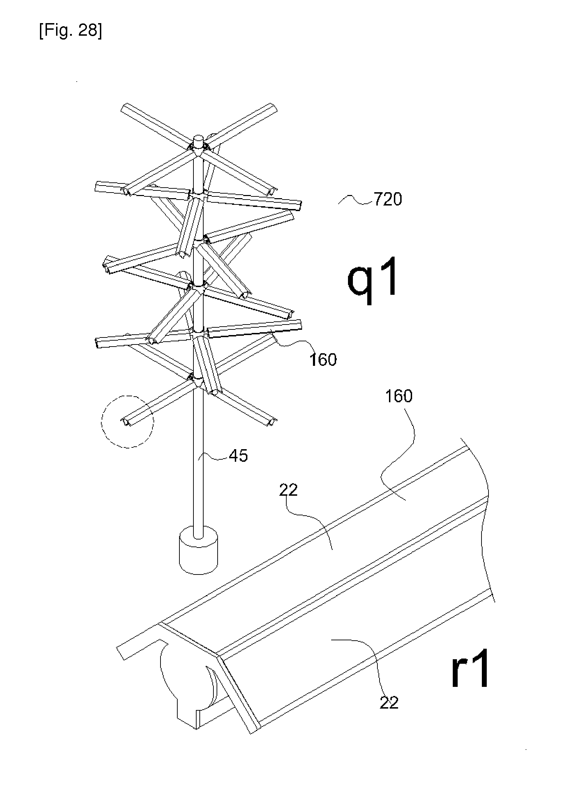

FIG. 28q1 is a perspective view showing a tree-shaped solar cell module 720, and FIG. 28r1 is an enlarged view showing a portion of a branch module 160. In the tree-shaped solar cell module 720, the above-described branch modules 160 are fixed to a pillar 45. Support rods fixed to the pillar 45 are inserted in internal space regions 67 of the branch modules 160 and are fixed using bolts. In this way, the tree-shaped solar cell module 720 can be assembled and used for solar power generation.

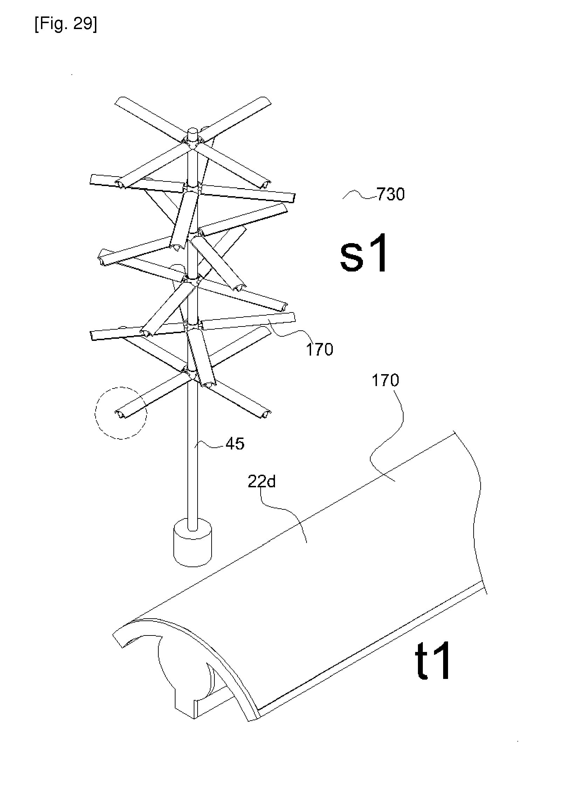

FIG. 29s1 is a perspective view showing a tree-shaped solar cell module 730, and FIG. 29t1 is an enlarged view showing a portion of a branch module 170. In the tree-shaped solar cell module 730, the above-described branch modules 170 are fixed to a pillar 45. Support rods fixed to the pillar 45 are inserted in internal space regions 67 of the branch modules 170 and are fixed using bolts. In this way, the tree-shaped solar cell module 730 can be assembled and used for solar power generation.

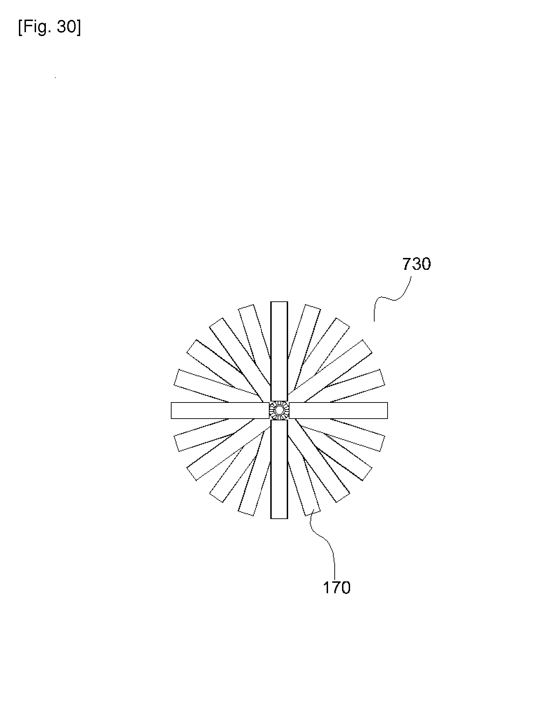

Referring to FIGS. 29 and 30, in the tree-shaped solar cell module 730, four branch modules 170 are radially arranged on each of six layers, and the layers are sequentially twisted 30 degrees. Referring to the plan view of FIG. 30, the branch modules 170 are overlapped with each other at the center region and are separated from each other at the circumferential region.

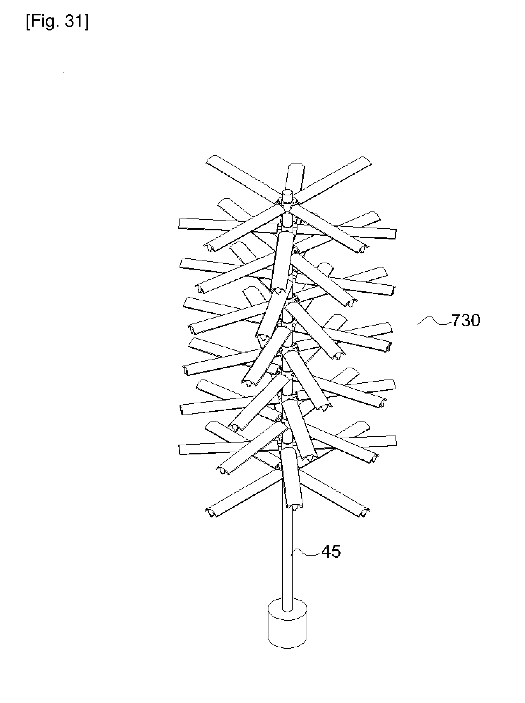

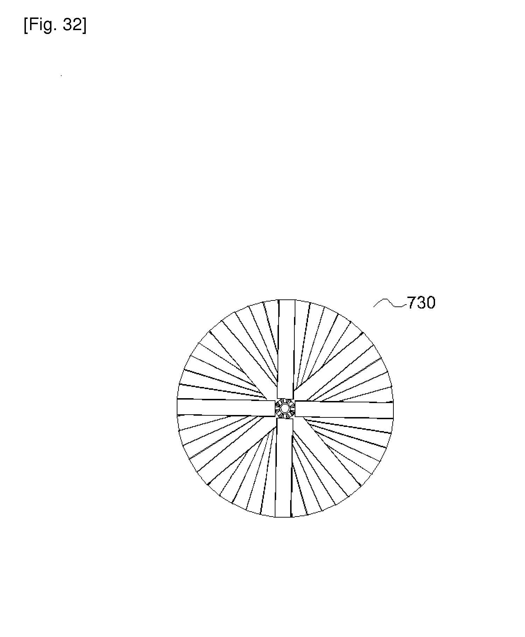

Referring to FIGS. 31 and 32, in the tree-shaped solar cell module 730, branch modules 170 are arranged in twelve layers, and each layers are twisted 15 degrees. Referring to the plan view of FIG. 32, the branch modules 170 are arranged without any gap at the circumferential region. Therefore, center portions of the branch modules 170 receive sunlight partially, and circumferential portions of the branch modules 170 receive sunlight fully.

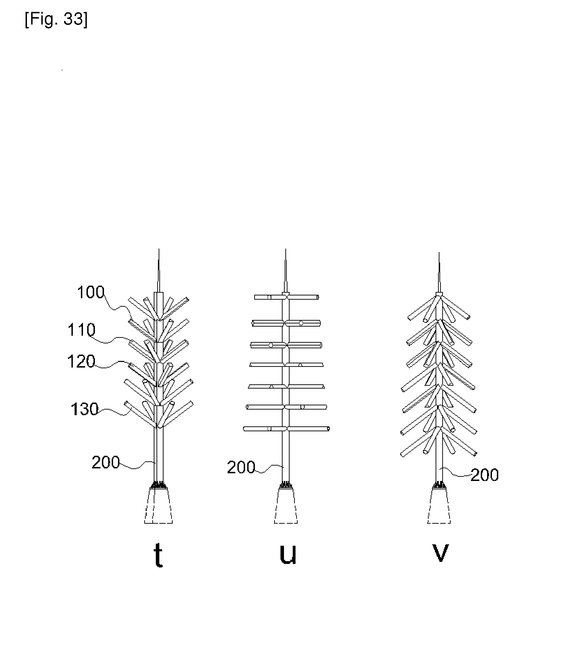

Referring to FIGS. 33t, 33u, and 33v, when the above-described branch modules are fixed to a trunk module, the branch modules can be oriented upward, horizontally, or downward.

Referring to FIG. 33t, triangular branch modules 100, quadrangular branch modules 110, rhombus branch modules 120, and circular branch modules 130 are upwardly fixed to fixing parts of a trunk module 200. Referring to FIG. 33u, such branch modules are horizontally oriented, and referring to FIG. 33v, such branch modules are downwardly oriented.

The above-described tree-shaped solar cell modules do not have solar cells corresponding to leaves but has solar cells on branch modules so that sunlight can go deep into the branch modules and trunk module for efficient power generation. In addition, since the tree-shaped solar cell modules do not have twigs and leaves, the tree-shaped solar cell modules can resist against strong wind. Furthermore, solar cells of the tree-shaped solar cell modules are disposed at high positions, power generation efficiency may not be reduced or less reduced by geothermal heat in desert regions. In other words, power generation efficiency of the tree-shaped solar cell modules may be higher than other solar cell modules.

Since the tree-shaped solar cell modules can be installed between small trees even on steep hills, a solar power plant can be constructed without destroying the natural environment. In addition, although the tree-shaped solar cell modules are installed on farmland, farming is possible between the tree-shaped solar cell modules. For example, pretty large crops such as fruit trees and corns can be grown between the tree-shaped solar cell modules. That is, almost all kinds of farming may be possible between the tree-shaped solar cell modules.

If the tree-shaped solar cell modules are installed in desert regions of China, since the tree-shaped solar cell modules weaken winds, less sand may be blown to delay the progress of desertification, and grassland may increase.

### Reference Signs List

| | |
|---|---|
| Lightening rod 1 | Utility pole cross arm 2 |
| Ground surface layer 3 | Plant 4 |
| Transformer 5 | Traffic light coupling part 6 |
| Traffic light support bar 7 | Traffic lights 8 |
| Streetlamp 9 | Triangular fame 10 |
| Quadrangular frame 10a | Hexagonal frame 10b |
| Octagonal frame 10c | Circular frame 10d |
| Corner 11 | Jaw 13 |
| Assembly space regions 12 and 12d | Wire accommodation grooves 14 and 14d |
| Internal cavity 16 | Sheet 17 |
| Solar cell 18 | Transparent glass plate 19 |
| Wire 20 | Simple solar cell module 22 |
| Simple solar cell module 22c | Simple solar cell module 22d |
| Module end 23 | Fixing plate 24 |
| Wire hole 25 | Fixing part 26 |
| Fixing hole 27 | Connection wires 30 and 33 |
| Connection plug 31 | Connection socket 34 |
| One-piece support part 35 | Fixing plate 36 |
| Wire hole 37 | Main wire 38 |
| Connection wire 39 | Triangular pillar 40 |
| Quadrangular pillar 40b | Octagonal pillar 40c |
| circular pillar 40d | Internal space regions 41, 41b, 41c, and 41d |
| Face 42 Face 42b, 42c, and 42d | Corners 43, 43b, 40c, and 40d |
| Pillar 45 | Branch fixing part 46 |
| Branch 47 | Solar cell module 48 |
| Solar cell 49 | Module auxiliary frames 50 and 50b |
| Screw assembly hole 53 | Back surfaces 54 and 54b |
| Ends 55 and 55b | Screw hole 58 |
| Fixing screw 59 | Branch module single frame 60 |
| Branched module dual frame 60a | Branched module multiple frame 60b |
| Branched module curve frame 60d | Corners 63 and 63a |
| One-piece parts 64, 64a, 64d Ends 65, 65a, and 65d | |
| Reinforcing fame 66 | Internal space region 67 |
| Bolt hole 68 | Fixing tab 70 |
| Fixing tab 71 | Gap 72 |
| Fixing bolt hole 73 | Fixing bolt 74 |
| Flowerpot 77 | Fixing part 78 |
| Tree 79 | Wire hole 80 |
| fixing plate 81 | Reinforcing plate 82 |
| Support end 83 | Nut hole 84 |
| Base 85 | Fixing bolt 86 |
| Nut 87 | Wire part 88 |
| Wire 89 | Branch coupling part 90 |
| Connection portion 92 | Coupling hole 95 |
| Wire hole 96 | Nut hole 97 |
| Coupling bolt 98 | Coupling nut 99 |
| triangular branch module 100 | Quadrangular branch module 110 |
| Rhombus branch module 120 | Circular branch module 130 |
| Branch module 140 | Branch module 150 |
| Branch module 160 | Branch module 170 |
| Trunk module 200 | Tree-shaped solar cell module 400 |
| Tree-shaped solar cell module 500 | Tree-shaped solar cell module 600 |
| Tree-shaped solar cell module 650 | Tree-shaped solar cell module 700 |
| Tree-shaped solar cell module 710 | Tree-shaped solar cell module 720 |
| Tree-shaped solar cell module 730 | |

## Claims

1. A tree-shaped solar cell module comprising:
the tree-shaped solar cell module (400):
the triangular branch module (100) coupled to the tree-shaped solar cell module (400);
the triangular frame (10) being a basic fame of the triangular branch modules (100);
the internal cavity (16) formed in the triangular frame (10);
the assembly space regions (12) and the jaws (13) at boundaries of the assembly space regions (12), the assembly space regions (12) being formed in three sides of the triangular frame (10) and having a depth of 5 mm to 10 mm;
the wire accommodation grooves (14) formed in the assembly space regions (12) and having a depth toward the internal cavity (16);
penetration holes formed from the wire accommodation grooves (14) to the internal cavity (16);
the fixing plate (24) provided on the fixing part 26 which is located on an end of the triangular frame (10);
the wire hole (25) formed through the fixing plate (24) and connected to the internal cavity (16); and
the fixing hole (27) formed in an edge portion of the fixing plate (24).

2. The tree-shaped solar cell module of claim 1, wherein the internal cavity (16) is not formed in the triangular frame (10), or the triangular frame (10) has a circular or polygonal shape.

3. The tree-shaped solar cell module of claim 1, wherein the fixing plate (24) is not flat but has an arc shape so as to be easily attached to a circular pillar having a corresponding diameter.

4. The tree-shaped solar cell module of claim 1, wherein the triangular frame (10) makes an angle of 100 degrees or less with the fixing plate (24) provided on the fixing part (26) formed on the end of the triangular frame (10).

5. The tree-shaped solar cell module of claim 1, wherein the triangular frame (10) is fixed in a manner such that the three sides of the triangular frame (10) are located at 0-degree, 120-degree, and 240-degree positions, or are located at 60-degree, 180-degree, and 300-degree positions based on the fixing plate (24) provided on the fixing part (26) formed on the end of the triangular frame (10).

6. The tree-shaped solar cell module of claim 1, wherein the simple solar cell modules (22) are attached to the assembly space regions (12), edges of the simple solar cell modules (22) are bonded to the jaws (13), wires of the simple solar cell modules (22) are arranged in the wire accommodation grooves (14) and introduced into the internal cavity (16) through the penetration holes and are pulled out through the wire hole 25 as the connection wires 30, and the connection plug (31) are connected to ends of the connection wires (30) so as to install the simple solar cell modules (22) to the triangular branch modules (100) .

7. The tree-shaped solar cell module of claim 6, wherein the sheets (17), the solar cells (18), and the transparent glass plates (19) are sequentially attached to the assembly space regions (12) instead of the simple solar cell modules (22).

8. The tree-shaped solar cell module of claim 6, wherein the LED modules are attached to the assembly space regions (12) instead of the simple solar cell modules (22).

9. The tree-shaped solar cell module of claim 6, wherein the reflection modules are attached to the assembly space regions (12) instead of the simple solar cell modules (22).

10. A tree-shaped solar cell module comprising:
the tree-shaped solar cell module (400):
the quadrangular branch module (110) or the rhombus branch module (120) coupled to the tree-shaped solar cell module (400);
the quadrangular frame (10a) being a basic fame of the quadrangular branch module (110) or the rhombus branch module (120);
the internal cavity (16) formed in the quadrangular frame (10a);
the assembly space regions (12) and the jaws (13) at boundaries of the assembly space regions (12), the assembly space regions (12) being formed in four sides of the quadrangular frame (10a) and having a depth of 5 mm to 10 mm;
the wire accommodation grooves (14) formed in the assembly space regions (12) and having a depth toward the internal cavity (16);
penetration holes formed from the wire accommodation grooves (14) to the internal cavity (16);
the fixing plate (24) provided on the fixing part 26 which is located on an end of the quadrangular frame (10a);
the wire hole (25) formed through the fixing plate (24) and connected to the internal cavity (16); and
the fixing hole (27) formed in an edge portion of the fixing plate (24).

11. The tree-shaped solar cell module of claim 10, wherein the four sides of the quadrangular frame (10a) are located at 0-degree, 90-degree, 180-degree, and 270-degree positions based on the fixing plate (24) provided on the end of the quadrangular frame (10a).

12. The tree-shaped solar cell module of claim 10, wherein the four sides of the quadrangular frame (10a) are located at 45-degree, 135-degree, 225-degree, and 315-degree positions based on the fixing plate (24) provided on the end of the quadrangular frame (10a).

13. The tree-shaped solar cell module of claim 10, wherein the assembly space regions (12) have a width of 50 mm to 300 mm.

14. The tree-shaped solar cell module of claim 10, wherein the quadrangular branch module (110) or the rhombus branch module (120) has a length of 1 m to 10 m.

15. A tree-shaped solar cell module comprising the quadrangular branch module (110) or the rhombus branch module (120) formed by attaching the simple solar cell modules (22) to the assembly space regions (12), bonding edges of the simple solar cell modules (22) to the jaws (13), arranging wires of the simple solar cell modules (22) in the wire accommodation grooves (14), introducing the wires into the internal cavity (16) through penetration holes, pulling the wires out through the wire hole 25 as the connection wires 30, connecting the connection plug (31) to ends of the connection wires (30).

16. A tree-shaped solar cell module comprising a polygonal frame including the triangular frame (10), the quadrangular frame (10a), a pentagonal frame, a hexagonal frame, a heptagonal frame, an octagonal frame, or a circular frame, the polygonal frame comprises:
the internal cavity (16);
the assembly space region (12) and the jaws (13) at boundaries of the assembly space region (12); and
the wire accommodation groove (14) formed in the assembly space region (12) and depth toward the internal cavity (16).

17. The tree-shaped solar cell module of claim 16, wherein the polygonal frame does not comprise the assembly space region (12) and the jaws (13) but comprises a polygonal pillar.

18. A tree-shaped solar cell module comprising:
the module auxiliary frame (50);
the assembly space region (12) and the jaws (13) at boundaries of the assembly space region (12), the assembly space region (12) being formed in a front side of the module auxiliary frame (50) to a depth of 5 mm to 10 mm;
the wire accommodation groove (14) formed in the assembly space region (12) and having a depth toward the back side (54);
the wire accommodation groove (14) formed in the assembly space region (12) and having a depth toward the back side (54);
a screw assembly hole (53) formed at the wire accommodation groove (14) and penetrating the back side (54); and
the ends (55) formed at both sides of the jaws (13) and having a right angle.

19. The tree-shaped solar cell module of claim 18, wherein the back side (54) comprising a back side (54) having a shape corresponding to an outer shape of the side (42b).

20. The tree-shaped solar cell module of claim 18, wherein the ends (55) comprise the ends (55b) having an angle of 108, 110, 112.5, 115, 120, 126, 135, or 150 degrees.

21. A tree-shaped solar cell module comprising:
the module auxiliary frame (50); and
the simple solar cell module (22) attached to the assembly space region (12), wherein wires of the simple solar cell module (22) are arranged in the wire accommodation groove (14), and the jaws (13) and edges of the simple solar cell module (22) are bonded to each other.

22. A tree-shaped solar cell module comprising a branch module or a trunk module in which the back side (54) of the module auxiliary frame (50) to which the simple solar cell module (22) is attached is in contact with each side (42) of the polygonal pillar.

23. The tree-shaped solar cell module of claim 22, wherein the module auxiliary frame (50) is the module auxiliary frame (50b), and the polygonal pillar is the circular pillar (40d).

24. A tree-shaped solar cell module comprising:
the module auxiliary frame (50b) comprising the assembly space region (12); and
the simple solar cell module (22c) attached to the assembly space region (12), wherein edges of the simple solar cell module (22c) and the jaws (13) are bonded by silicone.

25. A tree-shaped solar cell module comprising:
the circular pillar (40d) having ends in a length direction, the ends having different diameters; and
the module auxiliary frame (50b) having ends in a length direction, the ends of the module auxiliary frame (50b) having different widths in proportion to the different diameters.

26. The tree-shaped solar cell module of claim 25, wherein jaws (13) formed at both ends of an assembly space region (12) of the module auxiliary frame (50b) have the same length and different widths.

27. A tree-shaped solar cell module comprising:
the tree-shaped solar cell module (700);
the branch module (140) coupled to the tree-shaped solar cell module (700);
the branch module frame (60) being a basic fame of the branch modules (140);
the assembly space region (12) and the jaws (13) at boundaries of the assembly space region (12), the assembly space region (12) being formed in the branch module frame (60) and having a depth of 5 mm to 10 mm;
the wire accommodation groove (14) formed in the assembly space region (12); the reinforcing frame (66) formed in one piece with the one-piece part (64) on a back side of the branch module frame (60);
an internal space region (67) provided in the reinforcing frame (66); and
the bolt hole (68) formed in the reinforcing frame (66) so that the internal space region (67) is exposed to an outside.

28. The tree-shaped solar cell module of claim 27, wherein the branch module frame (60) comprises the branch module curve frame (60d) having an arc shape.

29. The tree-shaped solar cell module of claim 27, wherein the branch module frame comprises two parts having a coupling angle of 120 degrees or three parts having a coupling angle of 135 degrees at the one-piece part formed in one piece with the reinforcing frame (66).

30. The tree-shaped solar cell module of claim 27, wherein the gap (72) is formed in the reinforcing frame (66) in a length direction thereof to open the internal space region (67), the fixing tabs (70, 71) protrude from both sides of the gap (72), and a plurality of fixing bolt holes (73) are formed in sides of the fixing tabs (70, 71).

31. A tree-shaped solar cell module comprising:
the tree-shaped solar cell module (400):
a trunk module (200) of the tree-shaped solar cell module (400);
the internal cavity or internal space region formed in the trunk module (200);
a wire hole (80) and a nut hole (84) formed in an outer side of the trunk module (200);
the main wire (38) and the connection plug (31), the main wire (38) being disposed in the fixing plate (81) provided on a lower end of the trunk module (200) and the internal cavity or the internal space region, the connection plug (31) being attached to an end of the main wire (38) pulled out to a lower side of the fixing plate 81; and
a connection wire (33) and a connection socket (34) provided on an end of the connection wire (33), the connection wire (33) being electrically connected to the main wire (38) and pulled out through the wire hole (80).

32. A tree-shaped solar cell module comprising:
the tree-shaped solar cell module (400): and
the rhombus branch module (120) provided on an outside of the trunk module (200) by coupling the connection plug (31) of the connection wire (30) of the rhombus branch module (120) to the connection socket (34) of the connection wire (33) of the trunk module (200), aligning the fixing holes (27) of the fixing plate (24) of the rhombus branch module (120) with the nut holes (84) of the trunk module (200), and tightening bolts therethrough.

33. The tree-shaped solar cell module of claim 32, wherein an o-ring or a silicone adhesive is disposed or applied between the fixing plate (24) of the rhombus branch module (120) and a fixing part of the trunk module (200) in which the nut holes (84) are formed, for reliable sealing and fixing.

34. The tree-shaped solar cell module of claim 32, wherein the rhombus branch module (120) attached to the trunk module (200) is the triangular branch modules (100), the quadrangular branch module (110), or the circular branch module (130).

35. The tree-shaped solar cell module of claim 32, wherein the rhombus branch modules (120) attached to the trunk module (200) form layers, and the rhombus branch modules (120) of the layers are staggered.

36. A tree-shaped solar cell module comprising:
the trunk module (200);
the branch coupling parts (90) configured to be coupled to an outside of the wafer (200);
three sides of the branch coupling parts (90);
wire holes (96) and nut holes (97) formed in the three sides;
coupling plates (91) provided on the branch coupling parts (90); and
the coupling holes (95) formed in the coupling plates (91);
wherein if the branch coupling parts (90) are brought into contact with each other, the branch coupling parts (90) are brought into contact with each other and the coupling holes (95) are aligned, and
the branch coupling parts (90) form an internal space region to dispose the trunk module (200) in the internal space region.

37. The tree-shaped solar cell module of claim 36, wherein the internal space region formed by the branch coupling parts (90) has a circular or polygonal shape.

38. A tree-shaped solar cell module comprising:
a one-piece support (35) formed in one piece with an outer side of the trunk module (200);
the fixing plate (36) provided on an end of the one-piece support (35); and
a wire hole and a bolt hole formed in the fixing plate (36).

39. A tree-shaped solar cell module comprising:
the tree-shaped solar cell module (600):
the trunk module (200) of the tree-shaped solar cell module (600);
the quadrangular branch module (100), the rhombus branch module (120), or the circular branch module (130) coupled to an outer side of the trunk module (200);
the utility pole crossarm (2) and the transformer (5) provided on an upper portion of the trunk module (200);
the lightening rod (1) provided on the upper portion of the trunk module (200);
the traffic light coupling part (6) provided on the upper portion of the trunk module (200);
the traffic light support bar (7) and the traffic lights (8) provided on the traffic light coupling part (6); and
the streetlamp (9) provided on the traffic light coupling part (6).

40. The tree-shaped solar cell module of claim 39, wherein the simple solar cell module (22) is provided on an outer side of at least one of the utility pole crossarm (2) and the traffic light support bar (7).

41. A tree-shaped solar cell module comprising:
the tree-shaped solar cell module (650):
the trunk module (200) of the tree-shaped solar cell module (650);
the flowerpot (77) provided on the fixing part (78) formed on at least one portion of an outer side of the trunk module (200); and
an internal space region formed in the flowerpot (77) and having an opened top side.

42. The tree-shaped solar cell module of claim 41, wherein the flowerpot (77) has a polygonal shape, and the opened top side of the flowerpot (77) is pointed upward.

43. The tree-shaped solar cell module of claim 41, wherein the capillary tube bundle is provided on a lower end of the internal space region of the flowerpot (77), and the capillary tube bundle extends to a lower side of the fixing plate (81) of the trunk module (200).

44. The tree-shaped solar cell module of claim 41, wherein the capillary tube bundle is formed of a stainless metal, a ceramic material including glass, a plastic, or a vinyl resin.

45. A tree-shaped solar cell module comprising:
the tree-shaped solar cell module (700);
the pillar (45) of the tree-shaped solar cell module (700);
the fixing rod disposed on an outer side of the pillar (45); and
the branch module (140), the branch module (150), the branch module (160), or the branch module (170) fixed to the fixing rod.

46. A tree-shaped solar cell module comprising the triangular branch modules (100), the quadrangular branch module (110), the rhombus branch module (120), the circular branch module (130), the trunk module (200), or the pillar (45) that is straight, gradually curved, or gradually twisted in a length direction thereof.

47. A tree-shaped solar cell module comprising the triangular frame (10), the quadrangular frame (10a), the hexagonal frame (10b), the octagonal frame (10c), or the circular frame (10d) that is formed of a metal, aluminum, stainless steel, a ceramic material, glass, concrete, a plastic, a resin, a vinyl resin, or a combination thereof.
